(19) **Europäisches Patentamt European Patent Office Office européen des brevets**

(11) **EP 4 636 360 A1**

(12) **EUROPEAN PATENT APPLICATION**

(43) Date of publication:
**22.10.2025 Bulletin 2025/43**

(21) Application number: **24171140.7**

(22) Date of filing: **18.04.2024**

(51) International Patent Classification (IPC):
**G01D 5/14** *(2006.01)* **G01D 3/036** *(2006.01)*
**G06F 3/0338** *(2013.01)* **G01B 7/30** *(2006.01)*
**G01R 33/00** *(2006.01)*

(52) Cooperative Patent Classification (CPC):
**G01D 5/145; G01B 7/30; G01D 3/0365;
G01R 33/0005; G06F 3/0346**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Melexis Technologies SA
2022 Bevaix (CH)**

(72) Inventors:
• **DUPRE, Nicolas
2022 Bevaix (CH)**
• **TOMBEZ, Lionel
2022 Bevaix (CH)**
• **LAHAYE, Eric
3980 Tessenderlo (BE)**

(74) Representative: **Jacobs, Lambert
Inventrans BV
Overwegstraat 24
3740 Bilzen (BE)**

(54) **SENSOR DEVICE FOR DETERMINING AN ORIENTATION OF A MAGNET, AND SENSOR SYSTEM**

(57)     A sensor device for determining an orientation $(\alpha,\beta,\phi,\psi)$ of a magnet (701) that is pivotable about a reference point (Pref), the sensor device comprising a semiconductor substrate (703) comprising a first and a second magnetic sensor (51, 52) spaced apart in a first direction (X), each configured for measuring a first magnetic field component (Bx1, Bx2) oriented in the first direction (X), and a second magnetic field component (By1, By2) oriented in a second direction (Y); wherein the sensor device further comprises a processing circuit configured for determining: i) a first magnetic field gradient (dBx/dx); ii) a second magnetic field gradient (dBy/dx); iii) a first angle $(\alpha,\psi)$ based on the first magnetic field gradient (dBx/dx); iv) a second angle $(\beta,\phi)$ based on the second magnetic field gradient (dBy/dx). A sensor system comprising said sensor device and said magnet.

FIG. 7A

EP 4 636 360 A1

## Description

### Field of the invention

The present invention relates in general to the field of magnetic position sensor systems, devices and methods, and more in particular to magnetic position sensor devices for measuring a position of a magnet which is pivotable about a fixed reference point. The present invention is also related to a sensor system comprising said sensor device and said magnet, e.g. a sensor system wherein said magnet is connected to a joystick.

### Background of the invention

Magnetic position sensor systems, in particular linear or angular position sensor systems are known in the art. Many variants of position sensor systems exist, addressing one or more of the following requirements: using a simple or cheap magnetic structure, using a simple or cheap sensor device, being able to measure over a relatively large range, being able to measure with great accuracy, requiring only simple arithmetic, being able to measure at high speed, being highly robust against positioning errors, being highly robust against an external disturbance field, providing redundancy, being able to detect an error, being able to detect and correct an error, having a good signal-to-noise ratio (SNR), having only one degree of freedom (e.g. translation or rotation), having two degrees of freedom (e.g. one translation and one rotation, or two rotations), etc.

In many known systems, the system has only one degree of motional freedom, e.g. rotation about a single axis, or translation along a single axis.

Magnetic position sensor systems where the magnet has at least two degrees of freedom, are also known in the art, for example from EP3875915(A1) disclosing a magnet movable along an axis and rotatable about said axis; or from US2021/0110239(A1) disclosing a circuit comprising at least one trained neural network for determining information about a position, attitude, or orientation of a magnet. These examples show that position sensor systems wherein the magnet has at least 2 degrees of freedom are much more complicated than systems having only 1 degree of freedom.

EP4105768(A1) discloses a sensor system comprising: a semiconductor substrate having four magnetic sensors, and a magnet that is pivotable about a reference point, and that is magnetized in a direction perpendicular to the semiconductor substrate when the magnet is in its neutral position.

EP4357800(A1) will be published on 24/04/2024, and discloses devices and methods for determining an orientation of a magnet, using magnetic field gradients and correction values.

There is always room for improvements or alternatives.

### Summary of the invention

It is an object of embodiments of the present invention to provide a sensor device, and a sensor system for determining an orientation $(\psi,\phi,\alpha,\beta)$ (e.g. a unique position or a unique orientation) of a two-pole magnet which is pivotable about a fixed reference point. The fixed reference point may be situated at a predefined height above or below a semiconductor substrate ("above" meaning at the same side of the substrate as the magnet, "below" meaning at the opposite side of the substrate as the magnet).

In preferred embodiments, the orientation of the magnet is determined in a manner which is highly accurate, and/or has a reduced sensitivity to one or more or all of the following: temperature variations, mounting tolerances, demagnetization of the magnet, an external disturbance field (also known as "strayfield"), and/or requiring a simpler sensor arrangement, and/or requiring less sensor spots, and/or providing an alternative solution.

These and other objectives are accomplished by embodiments of the present invention.

According to a first aspect, the present invention provides a sensor device for determining an orientation (e.g. $\alpha,\beta,\phi,\psi$) of a two-pole magnet; the sensor device comprising a semiconductor substrate comprising or connected to at least a first and a second magnetic sensor (51, 52) spaced apart in a first direction (X) by a predefined distance (dx); wherein each of the first and second magnetic sensor (51, 52) is configured for measuring a first magnetic field component (e.g. Bx1, Bx2) oriented in said first direction (X), and a second magnetic field component (e.g. By1, By2) oriented in a second direction (e.g. Y) parallel to the semiconductor substrate and perpendicular to the first direction (e.g. X); wherein the magnet is movable relative to the sensor device such that a centre (P) of the magnet is pivotable about a reference point (Pref) having a predefined position relative to the semiconductor substrate (e.g. in the plane of the semiconductor substrate, above the semiconductor substrate, or below the semiconductor substrate); wherein the sensor device further comprises a processing circuit configured: i) for determining a first magnetic field gradient (e.g. dBx/dx) of the first magnetic field components (e.g. Bx1, Bx2) along said first direction (e.g. X); and ii) for determining a second magnetic field gradient (e.g. dBy/dx) of the second magnetic field components (e.g. By1, By2) along said first direction (e.g. X); and iii) for determining a first angle (e.g. $\alpha,\psi$) based on the first magnetic field gradient (e.g. dBx/dx); and iv) for determining a second angle (e.g. $\beta,\phi$) based on the second magnetic field gradient (e.g. dBy/dx).

Consider a virtual line segment [CP] formed between a point C in the middle between the first and second sensor and the point P in the centre of the magnet. The first angle $(\alpha,\psi)$ may be formed between a first orthogonal projection of the virtual line segment [CP] on a first virtual plane (XZ) parallel to the first direction (X) and a third direction (Z) perpendicular to the semiconductor substrate, and the first direction (X) or the third direction (Z).

The second angle ($\beta,\phi$) mag be formed between a second orthogonal projection of the virtual line segment [CP] on a second virtual plane (YZ) parallel to the second direction (Y) and the third direction (Z), and the second direction (Y) or the third direction (Z).

It was found that the orientation thus determined has an improved accuracy, and has a reduced sensitivity to one or more or all of the following: temperature variations, mounting tolerances, an external disturbance field, magnet demagnetisation, etc.

The semiconductor substrate may be a silicon substrate. It is noted that "semiconductor substrate comprising or connected to a plurality of magnetic sensors" does not necessarily mean that the sensors are embedded in the semiconductor substrate, although they may, and does not necessarily mean that the sensors have to be made of silicon. Indeed, the magnetic sensors may be formed on top of the silicon substrate, or next to the silicon substrate, and may comprise materials different from silicon, e.g. a ferromagnetic material (xMR), or a semiconductor compound (e.g. a III-V compound).

The processing circuit may be embedded in the semiconductor substrate that also comprises the magnetic sensors, but that is not absolutely required. In an embodiment, the sensor device comprises two silicon substrates, a first comprising the magnetic sensors, and a second comprising the processing circuit.

The processing circuit is preferably implemented in a cmos substrate, (i.e. a semiconductor substrate that is produced with a cmos compatible process).

In an embodiment, the magnet can be tilted about said reference point (Pref) by first angle $\psi$ in the range from -30° to +30°, and/or by a second angle $\phi$ in the range from -30° to +30°.

Preferably the semiconductor substrate has an area smaller than 9.0 mm$^2$, or smaller than 7.0 mm$^2$, or smaller than 5.0 mm$^2$, or smaller than 4.0 mm$^2$.

The magnet is a two-pole magnet, e.g. a cylindrical two-pole magnet, or a two-pole bar magnet, or a two-pole spherical magnet.

In an embodiment, the magnet is magnetized in a direction substantially parallel to the semiconductor substrate when a virtual line passing through the centre (P) of the magnet and through the reference point (Pref) is oriented substantially perpendicular to the semiconductor substrate.

In an embodiment, an orthogonal projection of the centre (P) of the magnet upon the semiconductor substrate, substantially coincides with a point (C) located in the middle between the first sensor (51) and the second sensor (S2).

In an embodiment, the magnet is magnetized in a direction substantially perpendicular to a virtual line passing through the centre (P) of the magnet and through the reference point (Pref).

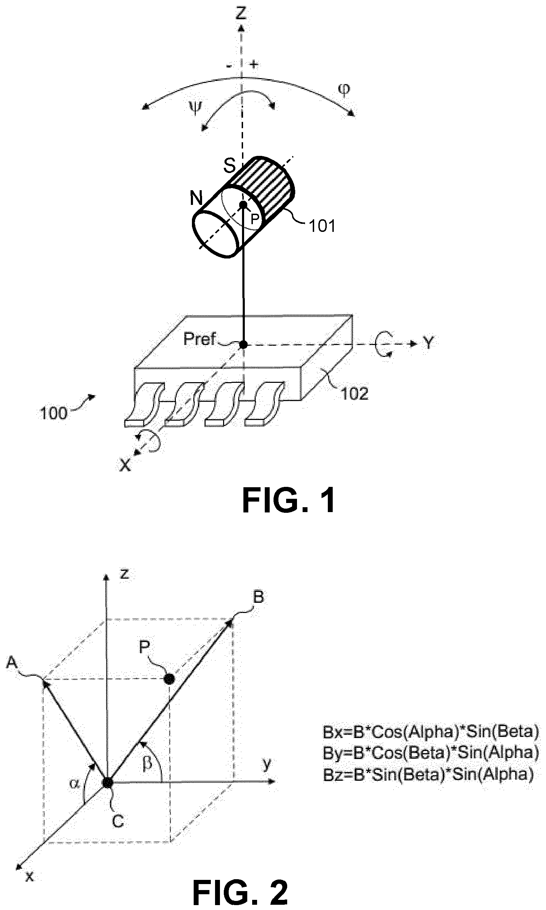

Or stated in simple terms: the magnet is magnetized in a direction parallel to the semiconductor substrate when the magnet is located in its "neutral position" (e.g. as illustrated in FIG. 1, FIG. 6A, FIG. 7A, FIG. 8A, FIG. 9A, FIG. 15, FIG. 23A), i.e. when $\psi$=0° and $\phi$°. With "orthogonal projection" is meant: "a projection in a direction (Z) perpendicular to the substrate". With "substantially coincides" is meant for example: "that the projection of the centre P is situated at a distance of at most 1.0 mm or at most 0.7 mm, or at most 0.5 mm, or at most 0.3 mm from the point C.

In an embodiment, the magnet has a cylindrical shape. The cylindrical shape may have a height in the range from 2.0 to 15.0 mm, and may have a diameter in the range from 2.0 to 15.0 mm. In an embodiment, the cylindrical shape has a height in the range from 3.0 mm to 8.0 mm, and has a diameter in the range from 3.0 to 8.0 mm.

In an embodiment, the magnet has a substantially cylindrical shape with a height and a diameter, wherein a ratio H/D of the height H and the diameter D is a value in the range from 50% to 200%, or in the range from 75% to 150%, or in the range from 80% to 130%, or in the range from 90% to 115%, or in the range from 50% to 100%, or in the range from 51% to 99%, or in the range from 101% to 200%.

In an embodiment, the magnet has a substantially ellipsoid shape.

In an embodiment, the magnet has a substantially spherical shape. The spherical shape may have a diameter in the range from 2.0 to 15.0 mm, or in the range from 3.0 mm to 8.0 mm.

In an embodiment, the magnet has a substantially beam shaped form.

In an embodiment, each of the first and second magnetic sensor (51, 52) is further configured for measuring a third magnetic field component (e.g. Bz1, Bz2) oriented in a third direction (e.g. Z) perpendicular to the substrate; and the processing circuit is configured: v) for determining a third magnetic field gradient (e.g. dBz/dx) of the third magnetic field component (e.g. Bz1, Bz2) along said first direction (e.g. X); iii) for determining the first angle (e.g. $\alpha,\psi$) based on the first and the third magnetic field gradient (e.g. dBx/dx, dBz/dx); and iv) for determining the second angle (e.g. $\beta,\phi$) based on the second and the third magnetic field gradient (e.g. dBy/dx, dBz/dx).

The first angle may be calculated as a function of a ratio of the first (dBx/dx) and the third magnetic field gradient (dBz/dx), for example as an arctan or atan2 function of said ratio.

The second angle may be calculated as a function of a ratio of the second (dBy/dx) and the third (dBz/dx) magnetic field gradient, for example as an arctan or atan2 function of said ratio.

The third magnetic field gradient is related (e.g. indicative) of the magnetic field strength of the magnet, and is substantially independent of the orientation of the magnet for small angular displacements of the magnet.

It is an advantage of this sensor device that the angular position is highly accurate, and has a reduced sensitivity to temperature variations, magnet demagnetization, mounting tolerances, and an external disturbance field.

In an embodiment, the sensor device further comprises a temperature sensor for measuring a temperature (e.g. a temperature of the magnet, or a temperature of the semiconductor substrate); and the processing circuit is configured: for determining a correction factor D1 as a predefined function of the measured temperature; and iii) for determining the first angle (e.g. $\alpha, \psi$) based on the first magnetic field gradient (e.g. dBx/dx) and the correction factor D1; iv) for determining the second angle (e.g. $\beta, \phi$) based on the second magnetic field gradient (e.g. dBy/dx) and the correction factor D1.

The first angle may be calculated as a function of a ratio of the first magnetic field gradient (dBx/dx) and the correction factor D1.

The second angle may be calculated as a function of a ratio of the second magnetic field gradient (dBy/dx) and the correction factor D1.

The temperature may be a temperature obtained from an internal temperature sensor incorporated in the sensor device, e.g. embedded in the silicon substrate, or may be a temperature obtained from an external temperature sensor (e.g. mounted to the magnet, or mounted in the vicinity of the magnet) and electrically connected to the sensor device.

The predefined function may be stored in a non-volatile memory of the sensor device, e.g. in the form of a look-up table, or in the form of a set of coefficients of a polynomial expression, or in any other suitable way.

It is an advantage of this sensor device that the angular position is highly accurate, and has a reduced sensitivity to temperature variations, and to and external disturbance field.

In an embodiment, the semiconductor substrate further comprises a third magnetic sensor (S3) located in the middle (C) between the first and the second magnetic sensor (51, S2), configured for determining two or more of the following: a magnetic field component (e.g. Bxc) oriented in the first direction (e.g. X), a magnetic field component (e.g. Byc) oriented in the second direction (e.g. Y), a magnetic field component (e.g. Bzc) oriented in the third direction (e.g. Z); and wherein the processing circuit is configured: for determining a correction factor D2 as a sum of squares of two or more of the magnetic field components (e.g. Bxc, Byc, Bzc) measured by the third magnetic sensor (e.g. S3); and iii) for determining the first angle (e.g. $\alpha, \psi$) based on the first magnetic field gradient (e.g. dBx/dx) and the correction factor D2; iv) for determining the second angle (e.g. $\beta, \phi$) based on the second magnetic field gradient (e.g. dBy/dx) and the correction factor D2.

The first angle may be calculated as a function of a ratio of the first magnetic field gradient (dBx/dx) and a square root of the correction factor D2.

The second angle may be calculated as a function of a ratio of the second magnetic field gradient (dBy/dx) and the square root of the correction factor D2.

In an embodiment, the processing circuit is configured: for determining a correction factor D3a as a sum of squares of the first and the second magnetic field gradient (e.g. dBx/dx, dBy/dx); and iii) for determining the first angle (e.g. $\alpha, \psi$) based on the first magnetic field gradient (e.g. dBx/dx) and the correction factor D3a; iv) for determining the second angle (e.g. $\beta, \phi$) based on the second magnetic field gradient (e.g. dBy/dx) and the correction factor D3a.

In this embodiment, the correction factor D3a is calculated as sqr(dBx/dx) + sqr(dBy/dx), in which case the sensors 51, 52 need to be capable of measuring Bx and By, but not necessarily Bz.

The first angle may be calculated as a function of a ratio of the first magnetic field gradient (dBx/dx) and a square root of the correction factor D3a.

The second angle may be calculated as a function of a ratio of the second magnetic field gradient (dBy/dx) and the square root of the correction factor D3a.

In an embodiment, each of the first and second magnetic sensor (51, 52) is further configured for measuring a third magnetic field component (e.g. Bz1, Bz2) oriented in a third direction (e.g. Z) perpendicular to the substrate; and the processing circuit is configured: for determining a third magnetic field gradient (e.g. dBz/dx) of the third magnetic field component (e.g. Bz1, Bz2) along said first direction (e.g. X); and for determining a correction factor D3b as a sum of squares of two or three of said first, second and third magnetic field gradient (e.g. dBx/dx, dBy/dx, dBz/dx); and iii) for determining the first angle (e.g. $\alpha, \psi$) based on the first magnetic field gradient (e.g. dBx/dx) and the correction factor D3b; iv) for determining the second angle (e.g. $\beta, \phi$) based on the second magnetic field gradient (e.g. dBy/dx) and the correction factor D3b.

The correction factor D3b may be calculated as sqr(dBx/dx) + sqr(dBz/dx).

The correction factor D3b may be calculated as sqr(dBy/dx) + sqr(dBz/dx).

The correction factor D3b may be calculated as sqr(dBx/dx) + sqr(dBy/dx) + sqr(dBz/dx).

The first angle may be calculated as a function of a ratio of the first magnetic field gradient (e.g. dBx/dx) and a square root of the correction factor D3b.

The second angle may be calculated as a function of a ratio of the second magnetic field gradient (e.g. dBy/dx) and the square root of the correction factor D3b.

In an embodiment, the semiconductor substrate further comprises a third magnetic sensor (S3) located in the middle (C) between the first and the second magnetic sensor (51, S2), and configured for determining a magnetic field component (e.g. Bxc) oriented in the first direction (e.g. X), and a magnetic field component (e.g.

Byc) oriented in the second direction (e.g. Y); and wherein the processing circuit is configured: for determining a second order gradient (e.g. d2Bx/dx2) of the first magnetic field component (e.g. Bx) along the first direction (e.g. X), and a second order gradient (e.g. d2By/dx2) of the second magnetic field component (By) along the first direction (X); and for determining a correction factor D4a as a sum of squares of these second order gradients; and iii) for determining the first angle (e.g. $\alpha,\psi$) based on the first magnetic field gradient (e.g. dBx/dx) and the correction factor D4a; iv) for determining the second angle (e.g. $\beta,\phi$) based on the second magnetic field gradient (e.g. dBy/dx) and the correction factor D4a.

In this embodiment, the three sensors 51, S2, S3 need to be capable of measuring Bx and By, but not necessarily Bz.

The first angle may be calculated as a function of a ratio of the first magnetic field gradient (e.g. dBx/dx) and a square root of the correction factor D4a.

The second angle may be calculated as a function of a ratio of the second magnetic field gradient (e.g. dBy/dx) and the square root of the correction factor D4a.

In an embodiment, each of the first and second magnetic sensor (51, 52) is further configured for measuring a third magnetic field component (e.g. Bz1, Bz2) oriented in a third direction (e.g. Z) perpendicular to the substrate; and wherein the semiconductor substrate further comprises a third magnetic sensor (e.g. S3) located in the middle (C) between the first and the second magnetic sensor (51, 52), configured for determining a magnetic field component (e.g. Bxc) oriented in the first direction (e.g. X), a magnetic field component (e.g. Byc) oriented in the second direction (e.g. Y), a magnetic field component (e.g. Bzc) oriented in the third direction (e.g. Z); and wherein the processing circuit is configured: for determining one or more of the following: a second order gradient (e.g. d2Bx/dx2) of the first magnetic field component (e.g. Bx) along the first direction (e.g. X), a second order gradient (e.g. d2By/dx2) of the second magnetic field component (e.g. By) along the first direction (e.g. X), a second order gradient (e.g. d2Bz/dx2) of the third magnetic field component (e.g. Bz) along the first direction (e.g. X); and for determining a correction factor D4b as a sum of squares of two or three of said second order gradients; and iii) for determining the first angle (e.g. $\alpha,\psi$) based on the first magnetic field gradient (e.g. dBx/dx) and the correction factor D4b; iv) for determining the second angle (e.g. $\beta,\phi$) based on the second magnetic field gradient (e.g. dBy/dx) and the correction factor D4b.

The correction factor D4b may be calculated as sqr(d2Bx/dx2) + sqr(d2Bz/dx2).

The correction factor D4b may be calculated as sqr(d2By/dx2) + sqr(d2Bz/dx2).

The correction factor D4b may be calculated as sqr(d2Bx/dx2) + sqr(d2By/dx2) + sqr(d2Bz/dx2).

The first angle may be calculated as a function of a ratio of the first magnetic field gradient (e.g. dBx/dx) and a square root of the correction factor D4b.

The second angle may be calculated as a function of a ratio of the second magnetic field gradient (e.g. dBy/dx) and the square root of the correction factor D4b.

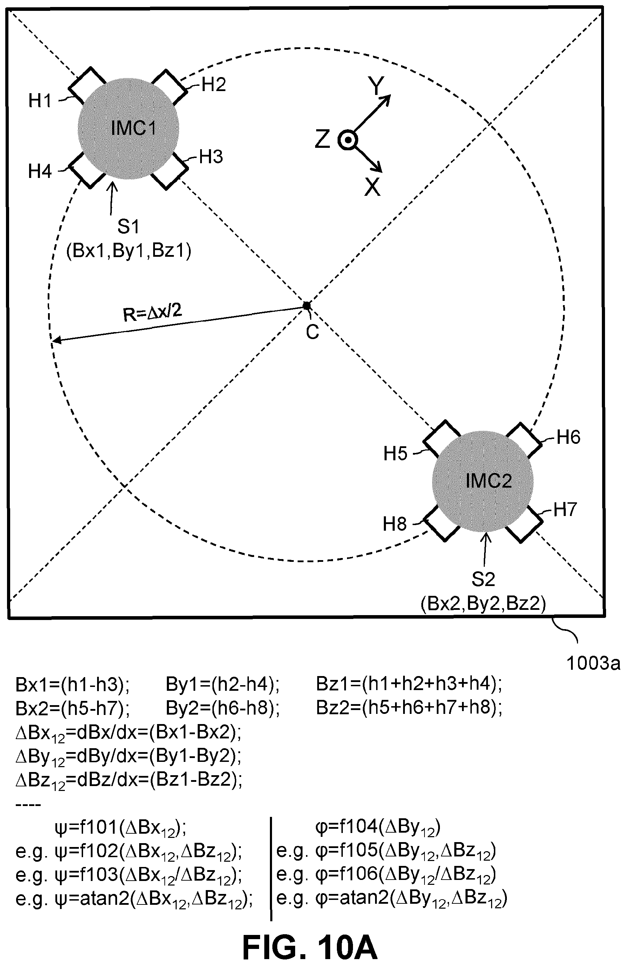

In an embodiment, the semiconductor substrate comprises or is connected to two (e.g. only two) magnetic pixels 51, 52 situated on a virtual line X, and each of the first and second magnetic sensor comprises an integrated magnetic flux concentrators (IMC) and four horizontal Hall elements arranged near a periphery of the IMC, angularly spaced apart by multiples of 90°, e.g. as illustrated in FIG. 10A to FIG. 10D.

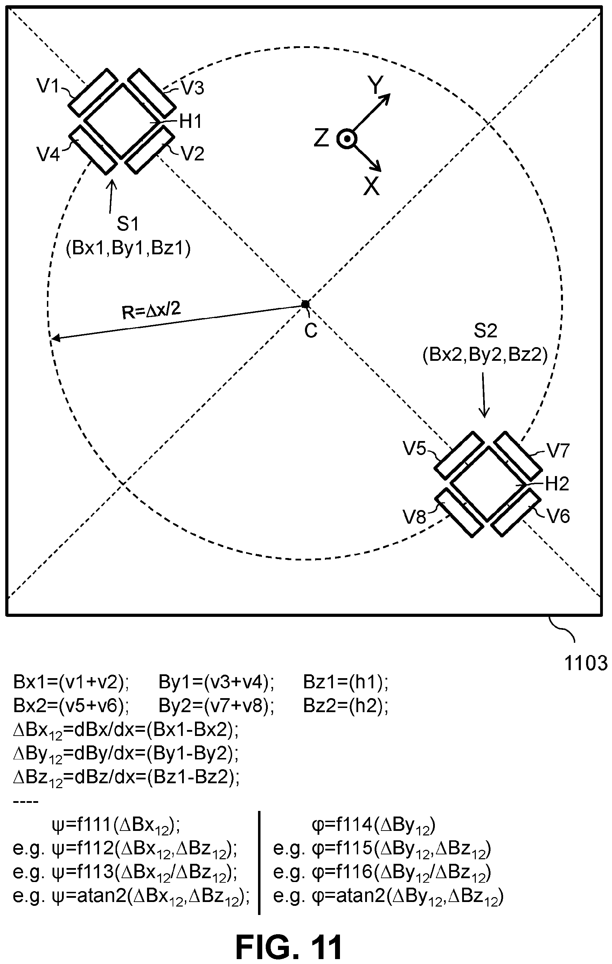

In an embodiment, the semiconductor substrate comprises or is connected to two (e.g. only two) magnetic pixels 51, 52 situated on a virtual line X, and each of the first and second magnetic sensor comprises a horizontal Hall element, and one or two vertical Hall element arranged for measuring Bx, and one or two vertical Hall element arranged for measuring By, e.g. as illustrated in FIG. 11.

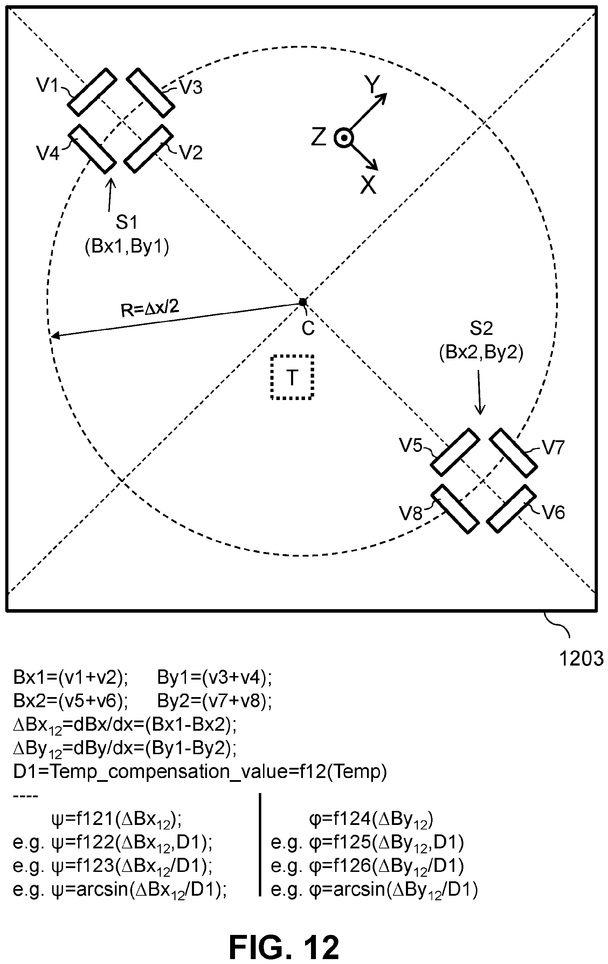

In an embodiment, the semiconductor substrate comprises or is connected to two (e.g. only two) magnetic pixels 51, 52 situated on a virtual line X, and each of the first and second magnetic sensor comprises one or two vertical Hall elements arranged for measuring Bx, and one or two vertical Hall elements for measuring By, e.g. as illustrated in FIG. 12.

In an embodiment, the semiconductor substrate comprises or is connected to two (e.g. only two) magnetic pixels 51, 52 situated on a virtual line X, and each of the first and second magnetic sensor comprises one or more magneto-resistive (MR) elements arranged for measuring Bx, and one or more magneto-resistive (MR) elements arranged for measuring By.

In an embodiment, the semiconductor substrate comprises or is connected to three magnetic pixels 51, S2, S3 situated on a virtual line X, and each of these magnetic sensors comprises an integrated magnetic flux concentrators (IMC) and four horizontal Hall elements arranged near a periphery of the IMC, angularly spaced apart by multiples of 90°.

In an embodiment, the semiconductor substrate comprises or is connected to three magnetic pixels 51, S2, S3 situated on a virtual line X, and each of these magnetic sensors comprises one or two vertical Hall elements arranged for measuring Bx, and one or two vertical Hall elements arranged for measuring By, but no horizontal Hall elements.

In an embodiment, the semiconductor substrate comprises or is connected to three magnetic pixels 51, S2, S3 situated on a virtual line X, and each of these magnetic sensors comprises one or more magneto-resistive (MR) elements arranged for measuring Bx, and one or more magneto-resistive (MR) elements arranged for measuring By.

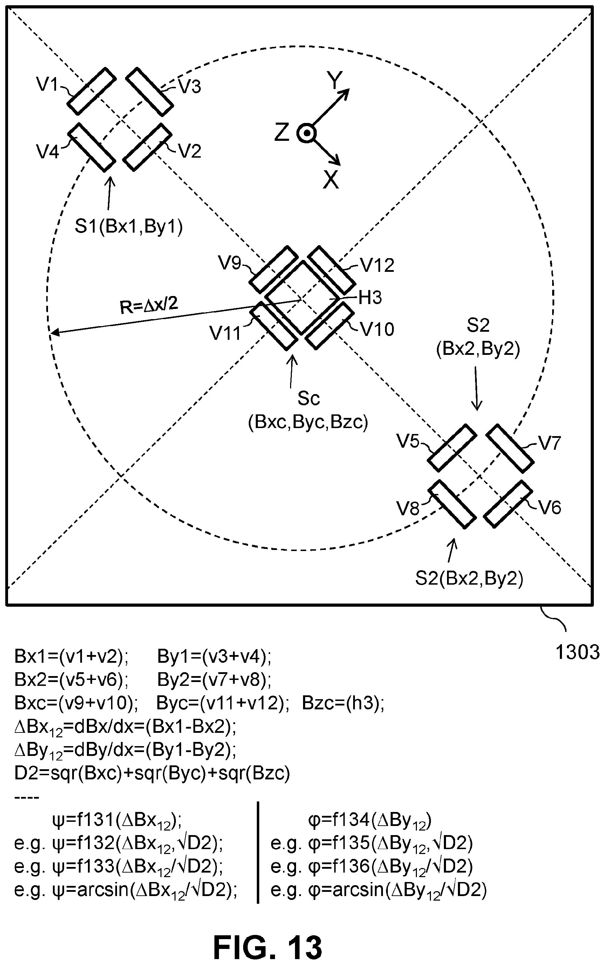

In an embodiment, the semiconductor substrate comprises or is connected to three magnetic pixels 51, S2, S3 situated on a virtual line X, and each of these magnetic sensors comprises one or two vertical Hall elements arranged for measuring Bx, and one or two vertical Hall elements arranged for measuring By, but only the magnetic pixel S3 located between S1 and S2 furthermore contains a horizontal Hall element, e.g. as illustrated in FIG. 13

The present invention also provides a sensor system comprising: a magnetic sensor device according to the first aspect; and said two-pole magnet.

The two-pole magnet is preferably magnetized in a direction parallel to the semiconductor substrate when the line segment [CP] is oriented substantially perpendicular to the semiconductor substrate (e.g. within a tolerance margin of ±10° or ±5°).

The sensor system may be a joystick assembly.

The sensor system may further comprise a joystick connected to the magnet, or comprising said magnet.

In an embodiment, the magnet has a cylindrical shape with a diameter D, and is mounted such that a distance "g" between a centre (P) of the magnet and the point (C) located in the middle between the first sensor (51) and the second sensor (52) is at least 2.0 mm + (D/2), and is at most 10.0 mm + (D/2), when the point P is situated "vertically above" the point C, i.e. when the magnet is in its "neutral position".

According to a second aspect, the present invention provides a sensor device for determining an orientation (e.g. $\alpha,\beta,\phi,\psi$) of a two-pole magnet; the sensor device comprising a semiconductor substrate comprising or connected to at least four magnetic sensors (e.g. 51, S2, S3, S4) situated on a virtual ellipse, including a first and a second magnetic sensor (51, 52) spaced apart in a first direction (e.g. X) by a first predefined distance (e.g. dx), and including a third and a fourth magnetic sensor (e.g. S3, S4) spaced apart by a second predefined distance (e.g. dy, equal to dx, larger than dx, or smaller than dx in a second direction (e.g. Y) parallel to the semiconductor substrate and perpendicular to the first direction (e.g. X); wherein each magnetic sensor (e.g. 51, S2, S3, S4) is configured for measuring a first magnetic field component (e.g. Bx1, Bx2, Bx3, Bx4) oriented in said first direction (e.g. X); wherein the magnet is movable relative to the sensor device such that a centre (P) of the magnet is pivotable about a reference point (Pref) having a predefined position relative to the semiconductor substrate (e.g. in the plane of the semiconductor substrate, above the semiconductor substrate, or below the semiconductor substrate); wherein the sensor device further comprises a processing circuit configured: i) for determining a first magnetic field gradient (e.g. dBx/dx) along said first direction (e.g. X) based on signals obtained from the first and the second sensor (51, S2); and ii) for determining a second magnetic field gradient (e.g. dBx/dy) along said second direction (e.g. Y) based on signals obtained from the third and the fourth sensor (e.g. S3, S4); and iii) for determining a first angle (e.g. $\alpha,\psi$) based on the first magnetic field gradient (e.g. dBx/dx); and iv) for determining a second angle (e.g.

$\beta,\phi$) based on the second magnetic field gradient (e.g. dBx/dy).

The same comments (regarding e.g. the line segment [CP], the first angle $\alpha$ or $\psi$, the second angle $\beta$ or $\phi$, the semiconductor substrate(s) and cmos substrate) as were made for claim 1, are also applicable here.

In an embodiment, the magnet is magnetized in a direction substantially parallel to the semiconductor substrate when a virtual line passing through the centre (P) of the magnet and through the reference point (Pref) is oriented substantially perpendicular to the semiconductor substrate.

In an embodiment, an orthogonal projection of the centre (P) of the magnet upon the semiconductor substrate, substantially coincides with a point (C) located in the middle between the first sensor (51) and the second sensor (S2).

The same comments (regarding e.g. "neutral position", and possible shapes of the magnet) as were made for claim 2, are also applicable here.

In an embodiment, the magnet is magnetized in a direction substantially perpendicular to a virtual line passing through the centre (P) of the magnet and through the reference point (Pref).

In an embodiment, each of the first and second magnetic sensor (51, 52) is further configured for measuring a third magnetic field component (e.g. Bz1, Bz2) oriented in a third direction (e.g. Z) perpendicular to the substrate; and wherein the processing circuit is configured: v) for determining a third magnetic field gradient (e.g. dBz/dx) of the third magnetic field component (e.g. Bz1, Bz2) along said first direction (e.g. X); and iii) for determining the first angle (e.g. $\alpha,\psi$) based on the first and the third magnetic field gradient (e.g. dBx/dx, dBz/dx); and iv) for determining the second angle (e.g. $\beta,\phi$) based on the second and the third magnetic field gradient (e.g. dBx/dy, dBz/dx).

The first angle may be calculated as a function of a ratio of the first (dBx/dx) and the third magnetic field gradient (dBz/dx), for example as an arctan or atan2 function of said ratio.

The second angle may be calculated as a function of a ratio of the second (dBx/dy) and the third (dBz/dx) magnetic field gradient, for example as an arctan or atan2 function of said ratio.

It is an advantage of this sensor device that the angular position is highly accurate, and has a reduced sensitivity to temperature variations, magnet demagnetization, mounting tolerances, and an external disturbance field.

In an embodiment, each magnetic sensor (e.g. 51, S2, S3, S4) is further configured for measuring a third magnetic field component (e.g. Bz1, Bz2, Bz3, Bz4) oriented in a third direction (e.g. Z) perpendicular to the substrate; and wherein the processing circuit is configured: v) for determining a third magnetic field gradient (e.g. dBz/dx) of the third magnetic field components (e.g. Bz1, Bz2) obtained from the first and second magnetic sensor (e.g. 51, S2) along said first direction (e.g. X); and vi) for determining a fourth magnetic field gradient (e.g. dBz/dy) of the third magnetic field components (e.g. Bz3, Bz4) obtained from the third and fourth magnetic sensor (e.g. S3, S4) along said second direction (e.g. Y); and iii) for determining the first angle (e.g. α,ψ) based on the first and the third magnetic field gradient (e.g. dBx/dx, dBz/dx); and iv) for determining the second angle (e.g. β,φ) based on the second and the fourth magnetic field gradient (e.g. dBx/dy, dBz/dy).

The first angle may be calculated as a function of a ratio of the first (dBx/dx) and the third magnetic field gradient (dBz/dx), for example as an arctan or atan2 function of said ratio.

The second angle may be calculated as a function of a ratio of the second (dBx/dy) and the fourth (dBz/dy) magnetic field gradient, for example as an arctan or atan2 function of said ratio.

In an embodiment, the sensor device further comprising a temperature sensor for measuring a temperature (e.g. a temperature of the magnet, or a temperature of the semiconductor substrate); and wherein the processing circuit is configured: for determining a correction factor D1 as a predefined function of the measured temperature; and iii) for determining the first angle (e.g. α,ψ) based on the first magnetic field gradient (e.g. dBx/dx) and the correction factor D1; iv) for determining the second angle (e.g. β,φ) based on the second magnetic field gradient (e.g. dBx/dy) and the correction factor D1.

The first angle may be calculated as a function of a ratio of the first magnetic field gradient (dBx/dx) and the correction factor D1.

The second angle may be calculated as a function of a ratio of the second magnetic field gradient (dBx/dy) and the correction factor D1.

In an embodiment, the semiconductor substrate further comprises a fifth magnetic sensor (e.g. Sc) located in the middle (C) between the first and the second magnetic sensor (51, S2), configured for determining two or more of the following: a magnetic field component (e.g. Bxc) oriented in the first direction (X), a magnetic field component (e.g. Byc) oriented in the second direction (Y), a magnetic field component (e.g. Bzc) oriented in the third direction (Z); and wherein the processing circuit is configured: for determining a correction factor D2 as a sum of squares of two or more of the magnetic field components (e.g. Bxc, Byc, Bzc) measured by the fifth magnetic sensor (Sc); and iii) for determining the first angle (e.g. α,ψ) based on the first magnetic field gradient (e.g. dBx/dx) and the correction factor D2; iv) for determining the second angle (e.g. β,φ) based on the second magnetic field gradient (e.g. dBx/dy) and the correction factor D2.

The first angle may be calculated as a function of a ratio of the first magnetic field gradient (e.g. dBx/dx) and a square root of the correction factor D2.

The second angle may be calculated as a function of a ratio of the second magnetic field gradient (e.g. dBx/dy) and the square root of the correction factor D2.

In an embodiment, the processing circuit is configured: for determining a correction factor D3a as a sum of squares of the first and the second magnetic field gradient (e.g. dBx/dx, dBx/dy); and iii) for determining the first angle (e.g. α,ψ) based on the first magnetic field gradient (e.g. dBx/dx) and the correction factor D3a; iv) for determining the second angle (e.g. β,φ) based on the second magnetic field gradient (e.g. dBx/dy) and the correction factor D3a.

In this embodiment, the correction factor D3a is calculated as sqr(dBx/dx) + sqr(dBx/dy), in which case the sensors 51, S2, S3, S4 need to be capable of measuring Bx, but not necessarily By or Bz.

The first angle may be calculated as a function of a ratio of the first magnetic field gradient (e.g. dBx/dx) and a square root of the correction factor D3a.

The second angle may be calculated as a function of a ratio of the second magnetic field gradient (e.g. dBx/dy) and the square root of the correction factor D3a.

In an embodiment, at least two of the magnetic sensors (e.g. 51, S2, S3, S4) are further configured for measuring a third magnetic field component (e.g. Bz1, Bz2, Bz3, Bz4) oriented in a third direction (e.g. Z) perpendicular to the substrate; and wherein the processing circuit is configured: v) for determining a third magnetic field gradient (e.g. dBz/dx) of the third magnetic field components (e.g. Bz1, Bz2) obtained from the first and second magnetic sensor (51, 52) along said first direction (X); and vi) for determining a fourth magnetic field gradient (e.g. dBz/dy) of the third magnetic field components (e.g. Bz3, Bz4) obtained from the third and fourth magnetic sensor (e.g. S3, S4) along said second direction (e.g. Y); and wherein the processing circuit is configured: for determining a correction factor D3b as a weighted sum of at least two or at least three squares of the first, second, third and fourth magnetic field gradient (e.g. dBx/dx, dBx/dy, dBz/dx, dBz/dy); and iii) for determining the first angle (e.g. α,ψ) based on the first magnetic field gradient (e.g. dBx/dx) and the correction factor D3b; iv) for determining the second angle (e.g. β,φ) based on the second magnetic field gradient (e.g. dBx/dy) and the correction factor D3b.

In an embodiment, the correction factor D3b is calculated as w1*sqr(dBx/dx) + w2*sqr(dBx/dy) + w3*sqr(dBz/dx), wherein each of w1, w2, w3 is different from 0.0. In this case, the gradient dBz/dy does not need to be determined, thus step vi) can be omitted, S1 and S2 need to be capable to measure Bx and Bz, and S3 and S4 need to be capable of measuring Bx but not Bz.

In an embodiment, the correction factor D3b is calculated as w1*sqr(dBx/dx) + w2*sqr(dBx/dy) + w3*sqr(dBz/dy), wherein each of w1, w2, w3 is different from 0.0. In this case, the gradient dBz/dx does not need to be determined, thus step v) can be omitted, S1 and S2 need to be capable to measure Bx but not Bz, and S3 and S4 need to be capable of measuring Bx and Bz.

In an embodiment, the correction factor D3b is calculated as w1*sqr(dBx/dx) + w2*sqr(dBx/dy) + w3*sqr(dBz/dx) + w4*sqr(dBz/dy), wherein each of w1, w2, w3, w4 is different from 0.0. In this case, each of S1 to S4 needs to be capable to measure Bx and Bz.

The first angle may be calculated as a function of a ratio of the first magnetic field gradient (dBx/dx) and a square root of the correction factor D3b.

The second angle may be calculated as a function of a ratio of the second magnetic field gradient (dBx/dy) and the square root of the correction factor D3b.

In an embodiment, the semiconductor substrate further comprises a fifth magnetic sensor (e.g. Sc) located in the middle (e.g. C) between the first and the second magnetic sensor (e.g. 51, S2), and configured for determining a magnetic field component Bxc oriented in the first direction (e.g. X); and wherein the processing circuit is configured: v) for determining a second order gradient (e.g. d2Bx/dx2) of the first magnetic field component (e.g. Bx) along the first direction (e.g. X); and vi) for determining a second order gradient (e.g. d2Bx/dy2) of the first magnetic field component (e.g. Bx) along the second direction (e.g. Y); and for determining a correction factor D4a as a sum of squares of these second order gradients (e.g. d2Bx/dx2, d2Bx/dy2); and iii) for determining the first angle (e.g. $\alpha, \psi$) based on the first magnetic field gradient (e.g. dBx/dx) and the correction factor D4a; iv) for determining the second angle (e.g. $\beta, \phi$) based on the second magnetic field gradient (e.g. dBx/dy) and the correction factor D4a.

In this embodiment, D4a=sqr(d2Bx/dx2) +sqr(d2Bx/dy2), and the five sensors 51, S2, S3, S4, Sc need to be capable of measuring Bx, but not necessarily By or Bz.

The first angle may be calculated as a function of a ratio of the first magnetic field gradient (dBx/dx) and a square root of the correction factor D4a.

The second angle may be calculated as a function of a ratio of the second magnetic field gradient (dBx/dy) and the square root of the correction factor D4a.

In an embodiment, at least two of the four magnetic sensors (e.g. 51, S2, S3, S4) is further configured for measuring a third magnetic field component (e.g. Bz1, Bz2, Bz3, Bz4) oriented in a third direction (e.g. Z) perpendicular to the substrate; and wherein the semiconductor substrate further comprises a fifth magnetic sensor (e.g. Sc) located in the middle (e.g. C) between the first and the second magnetic sensor (e.g. 51, S2), configured for determining a magnetic field component (e.g. Bxc) oriented in the first direction (e.g. X) and a magnetic field component (e.g. Bzc) oriented in the third direction (e.g. Z); and wherein the processing circuit is configured: for determining two or more of the following: a second order gradient (e.g. d2Bx/dx2) of the first magnetic field component (e.g. Bx) along the first direction (e.g. X), a second order gradient (e.g. d2Bx/dy2) of the first magnetic field component (e.g. Bx) along the second direction (e.g. Y), a second order gradient (d2Bz/dx2) of the third magnetic field component (e.g. Bz) along the first direction (e.g. X), a second order gradient (e.g. d2Bz/dy2) of the third magnetic field component (e.g. Bz) along the second direction (e.g. Y); and for determining a correction factor D4b as a weighted sum of at least two or at least three or four squares of these second order magnetic field gradients (e.g. d2Bx/dx2, d2Bx/dy2, d2Bz/dx2, d2Bz/dy2); and iii) for determining the first angle (e.g. $\alpha, \psi$) based on the first magnetic field gradient (e.g. dBx/dx) and the correction factor D4b; iv) for determining the second angle (e.g. $\beta, \phi$) based on the second magnetic field gradient (e.g. dBy/dx) and the correction factor D4b.

In an embodiment, the correction factor D4b is calculated as w1*sqr(d2Bx/dx2) + w2*sqr(dB2x/dy2) + w3*sqr(d2Bz/dx2), wherein each of w1, w2, w3 is different from 0.0. In this case, the second order gradient d2Bz/dy2 does not need to be determined, 51, 52, Sc need to be capable to measure Bx and Bz, and S3, S4 need to be capable of measuring Bx but not necessarily Bz.

In an embodiment, the correction factor D4b is calculated as w1*sqr(d2Bx/dx2) + w2*sqr(dB2x/dy2) + w3*sqr(d2Bz/dy2), wherein each of w1, w2, w3 is different from 0.0. In this case, the second order gradient d2Bz/dx2 does not need to be determined, S3, S4, Sc need to be capable to measure Bx and Bz, and 51, S2 need to be capable of measuring Bx but not necessarily Bz.

In an embodiment, the correction factor D4b is calculated as w1*sqr(d2Bx/dx2) + w2*sqr(dB2x/dy2) + w3*sqr(d2Bz/dx2) + w4*sqr(d2Bz/dy2), wherein each of w1, w2, w3, w4 is different from 0.0. In this case, each of 51, S2, S3, S4, Sc need to be capable to measure Bx and Bz.

In an embodiment, the correction factor D4b is calculated as w1*sqr(d2Bz/dx2) + w2*sqr(d2Bz/dy2), wherein each of w1, w2 is different from 0.0. In this case, the second order gradients d2Bx/dx2 and d2Bx/dy2 do not need to be determined, and each of 51, S2, S3, S4, Sc need to be capable to measure Bx and Bz.

The first angle may be calculated as a function of a ratio of the first magnetic field gradient (e.g. dBx/dx) and a square root of the correction factor D4b.

The second angle may be calculated as a function of a ratio of the second magnetic field gradient (e.g. dBx/dy) and the square root of the correction factor D4b.

In an embodiment, the semiconductor substrate comprises or is connected to four magnetic sensors 51, S2, S3, S4 situated on a virtual ellipse, including two magnetic pixels 51, 52 situated on a virtual line X and spaced apart by a first distance (dx), and including two magnetic pixels S3, S4 situated on a virtual line Y and spaced apart by a second distance (dy).

In an embodiment, each of these four magnetic sensors is or comprises a vertical Hall element, arranged for measuring a Bx component, e.g. as illustrated in FIG. 17, FIG. 20, FIG. 21. Optionally the semiconductor substrate further comprises a temperature sensor, e.g. as illustrated in FIG. 20. Optionally the semiconductor substrate further comprises a 3D magnetic pixel located in the centre of the virtual ellipse, e.g. as illustrated in FIG. 21. This 3D magnetic pixel may comprise for example a horizontal Hall element and at least two vertical Hall elements, or may comprise an IMC and four horizontal Hall elements.

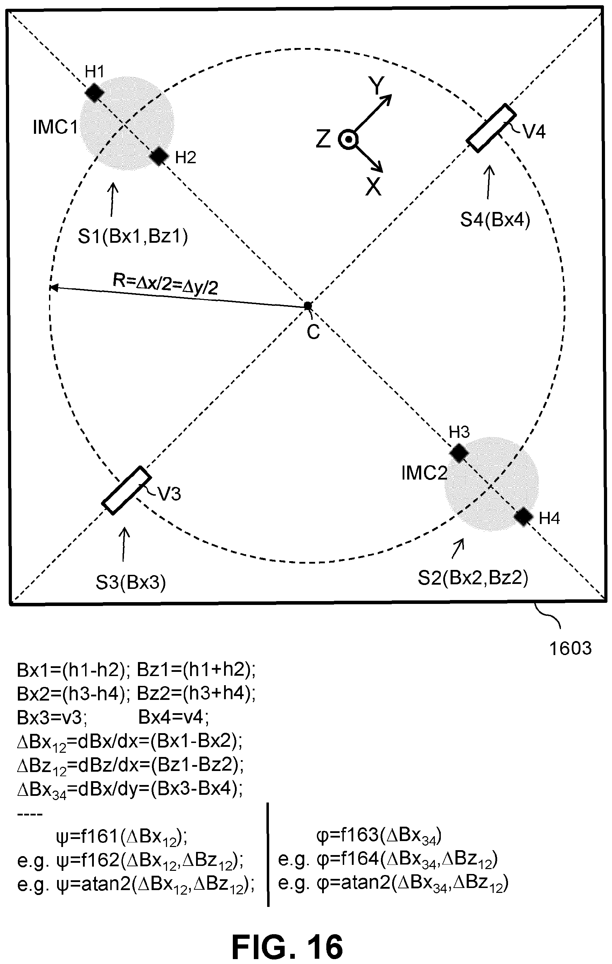

In an embodiment, each of the sensors 51, 52 comprises an integrated magnetic concentrator (IMC) and at least two horizontal Hall elements arranged for measuring a Bx and a Bz component; and each of the sensors S3, S4 is or comprises a vertical Hall element arranged for measuring a Bx component, e.g. as illustrated in FIG. 16.

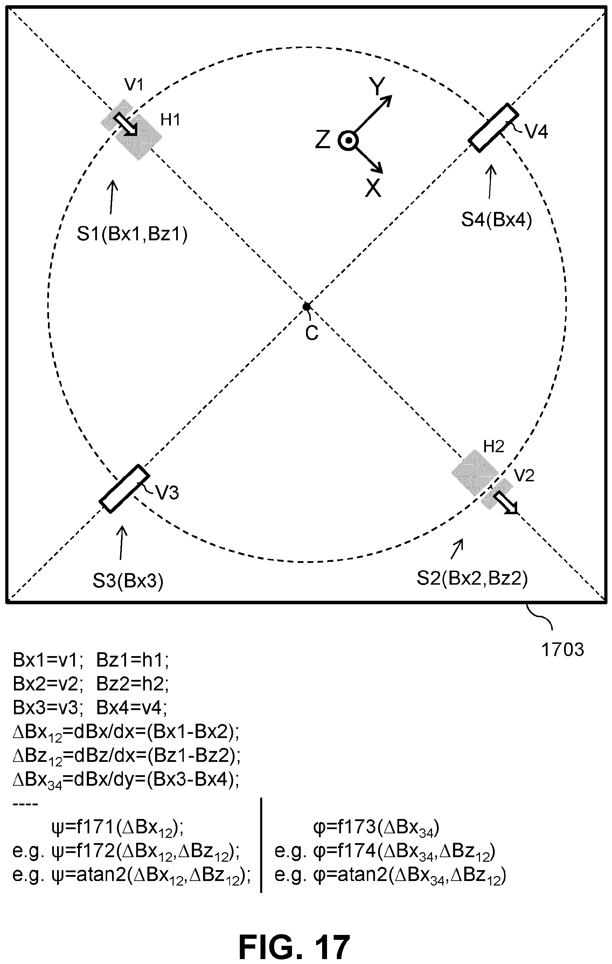

In an embodiment, each of the sensors S1, 52 comprises a horizontal Hall element for measuring a Bz component and a vertical Hall element for measuring a Bx component; and each of the sensors S3, S4 is or comprises a vertical Hall element arranged for measuring a Bx component, e.g. as illustrated in FIG. 17.

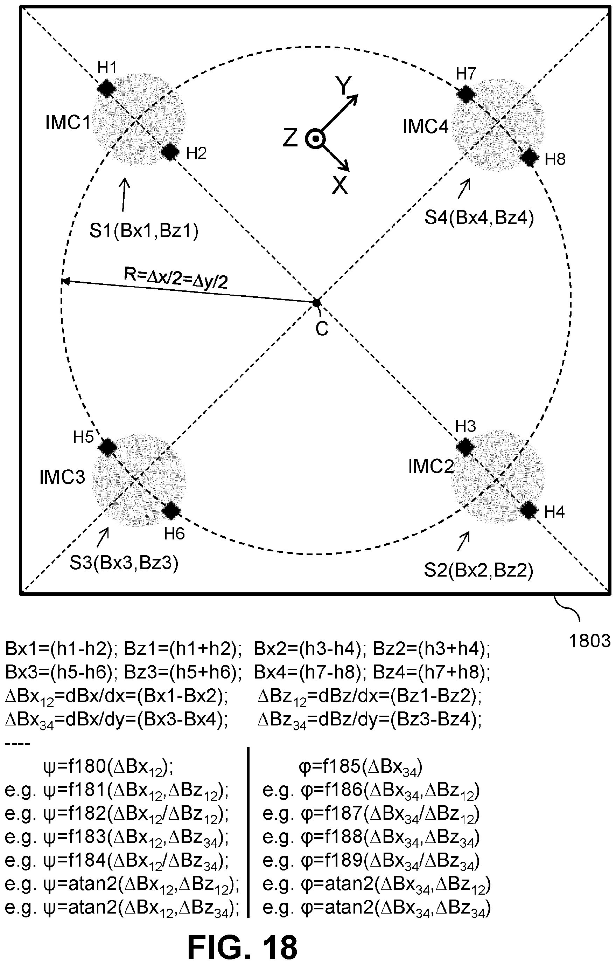

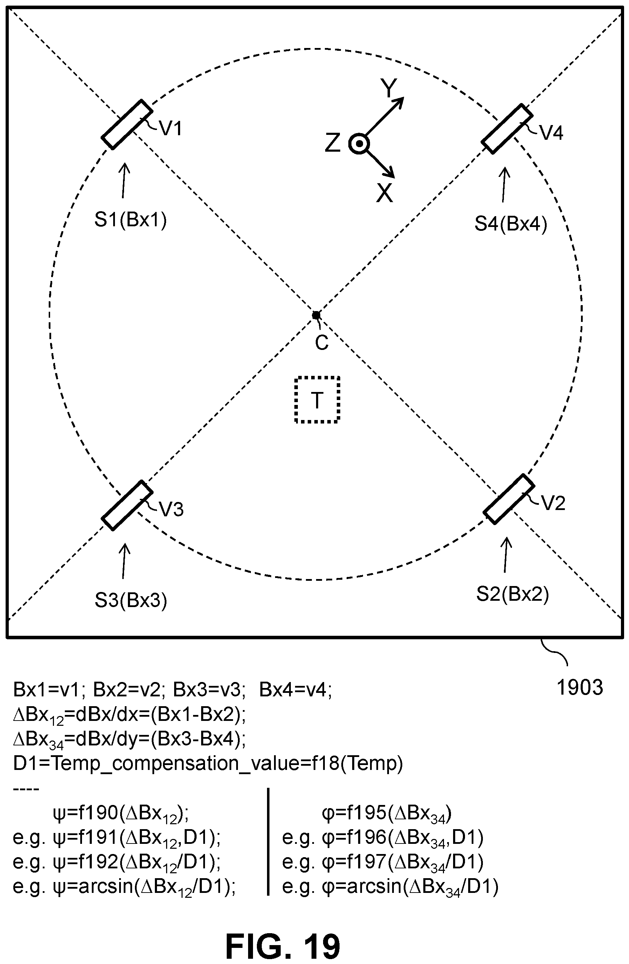

In an embodiment, each of the sensors 51, S2, S3, S4 comprises an integrated magnetic concentrator (IMC) and at least two horizontal Hall elements arranged for measuring a Bx and a Bz component, e.g. as illustrated in FIG. 18. Optionally the semiconductor substrate may further comprise a fifth sensor S5 arranged at the centre of the virtual ellipse, and also comprising an IMC and at least two horizontal Hall elements, e.g. as illustrated in FIG. 19.

In all embodiments mentioned above, magneto-resistive (MR) elements may be used instead of vertical Hall elements.

The present invention also provides a sensor system comprising: a magnetic sensor device according to the second aspect; and said two-pole magnet.

The two-pole magnet is preferably magnetized in a direction parallel to the semiconductor substrate when the line segment [CP] is oriented substantially perpendicular to the semiconductor substrate (e.g. within a tolerance margin of $\pm 10°$ or $\pm 5°$).

According to a third aspect, the present invention also provides a sensor device for determining an orientation (e.g. $\alpha, \beta, \phi, \psi$) of a two-pole magnet; the sensor device comprising a semiconductor substrate comprising or connected to a first and a second magnetic sensor (e.g. 51, S2) spaced apart in a first direction (e.g. X) by a predefined distance (e.g. dx), each of the first and second sensor (e.g. 51, S2) capable of measuring a magnetic field component (e.g. Bx1, Bx2) oriented in said first direction (e.g. X); the semiconductor substrate further comprising: a third and a fourth magnetic sensor (e.g. S5, S6) spaced apart in a second direction (e.g. Y) parallel to the semiconductor substrate and perpendicular to the first direction (e.g. X), the third and fourth sensor (e.g. S5, S6) being located on a virtual line YY which is offset (e.g. dxx) from a perpendicular bisector (e.g. Y) defined by the first and the second sensor (e.g. 51, 52), each of the third and fourth sensor (e.g. S5, S6) capable of measuring a magnetic field component (e.g. Bz5, Bz6) oriented in a third direction, perpendicular to the substrate; wherein the magnet is movable relative to the sensor device such that a centre (P) of the magnet is pivotable about a reference point (Pref) having a predefined position relative to the semiconductor substrate (e.g. in the plane of the semiconductor substrate, above the semiconductor substrate, or below the semiconductor substrate); wherein the sensor device further comprises a processing circuit configured: i) for determining a first magnetic field gradient (e.g. dBx/dx) of the magnetic field components (e.g. Bx1, Bx2) obtained from the first and second magnetic sensor (e.g. 51, S2) along the first direction (e.g. X); and ii) for determining a second magnetic field gradient (e.g. dBz/dy) of the magnetic field components (e.g. Bz5, Bz6) obtained from the third and fourth magnetic sensor (e.g. S5, S6) along the second direction (e.g. Y); and iii) for determining a first angle (e.g. $\alpha, \psi$) based on the first magnetic field gradient (e.g. dBx/dx); and iv) for determining a second angle (e.g. $\beta, \phi$) based on the second magnetic field gradient (e.g. dBz/dy).

The same comments (regarding e.g. the line segment [CP], the first angle $\alpha$ or $\psi$, the second angle $\beta$ or $\phi$, the semiconductor substrate(s) and cmos substrate) as were made for claim 1, are also applicable here.

In an embodiment, the magnet is magnetized in a direction substantially parallel to the semiconductor substrate when a virtual line passing through the centre (P) of the magnet and through the reference point (Pref) is oriented substantially perpendicular to the semiconductor substrate.

In an embodiment, an orthogonal projection of the centre (P) of the magnet upon the semiconductor substrate, substantially coincides with a point (C) located in the middle between the first sensor (51) and the second sensor (S2).

In an embodiment, the magnet is magnetized in a direction substantially perpendicular to a virtual line passing through the centre (P) of the magnet and through the reference point (Pref).

The same comments (regarding e.g. "neutral position", and possible shapes of the magnet) as were made for claim 2, are also applicable here.

In an embodiment, each of the first and second magnetic sensor (e.g. 51, S2) is further configured for measuring a magnetic field component (e.g. Bz1, Bz2) oriented in the third direction (e.g. Z) perpendicular to the substrate; and wherein the processing circuit is further configured: v) for determining a third magnetic field gradient (e.g. dBz/dx) of the magnetic field components (e.g. Bz1, Bz2) oriented in the third direction (e.g. Z) along the first direction (e.g. X); and iii) for determining the first angle (e.g. $\alpha, \psi$) based on the first and the third magnetic field gradient (e.g. dBx/dx, dBz/dx); and iv) for determining the second angle (e.g. $\beta, \phi$) based on the second and the third magnetic field gradient (e.g. dBz/dy, dBz/dx).

The first angle may be calculated as a function of a ratio of the first (e.g. dBx/dx) and the third magnetic field gradient (e.g. dBz/dx), for example as an arctan or atan2 function of said ratio.

The second angle may be calculated as a function of a ratio of the second (e.g. dBz/dy) and the third magnetic field gradient (e.g. dBz/dx), for example as an arctan or atan2 function of said ratio.

In an embodiment, the sensor device further comprises a temperature sensor for measuring a temperature; (e.g. a temperature of the magnets, or a temperature of the semiconductor substrate) and wherein the processing circuit is configured: for determining a correction factor D1 as a predefined function of the measured temperature; and iii) for determining the first angle (e.g. $\alpha, \psi$) based on the first magnetic field gradient (e.g. dBx/dx) and the correction factor D1; iv) for determining the second angle (e.g. $\beta, \phi$) based on the second magnetic field gradient (e.g. dBz/dy) and the correction factor D1.

The first angle may be calculated as a function of a ratio of the first magnetic field gradient (e.g. dBx/dx) and the correction factor D1.

The second angle may be calculated as a function of a ratio of the second magnetic field gradient (e.g. dBz/dy) and the correction factor D1.

In an embodiment, the semiconductor substrate further comprises a fifth magnetic sensor (e.g. Sc) located in the middle (e.g. C) between the first and the second magnetic sensor (e.g. 51, S2), configured for determining two or more of the following: a magnetic field component (e.g. Bxc) oriented in the first direction (e.g. X), a magnetic field component (e.g. Byc) oriented in the second direction (e.g. Y), a magnetic field component (e.g. Bzc) oriented in the third direction (e.g. Z); and wherein the processing circuit is configured: for determining a correction factor D2 as a sum of squares of two or more of the magnetic field component (Bxc, Byc, Bzc) measured by the fifth magnetic sensor (Sc); and iii) for determining the first angle (e.g. $\alpha, \psi$) based on the first magnetic field gradient (e.g. dBx/dx) and the correction factor D2; iv) for determining the second angle (e.g. $\beta, \phi$) based on the second magnetic field gradient (e.g. dBy/dx) and the correction factor D2.

The first angle may be calculated as a function of a ratio of the first magnetic field gradient (e.g. dBx/dx) and a square root of the correction factor D2.

The second angle may be calculated as a function of a ratio of the second magnetic field gradient (e.g. dBz/dy) and the square root of the correction factor D2.

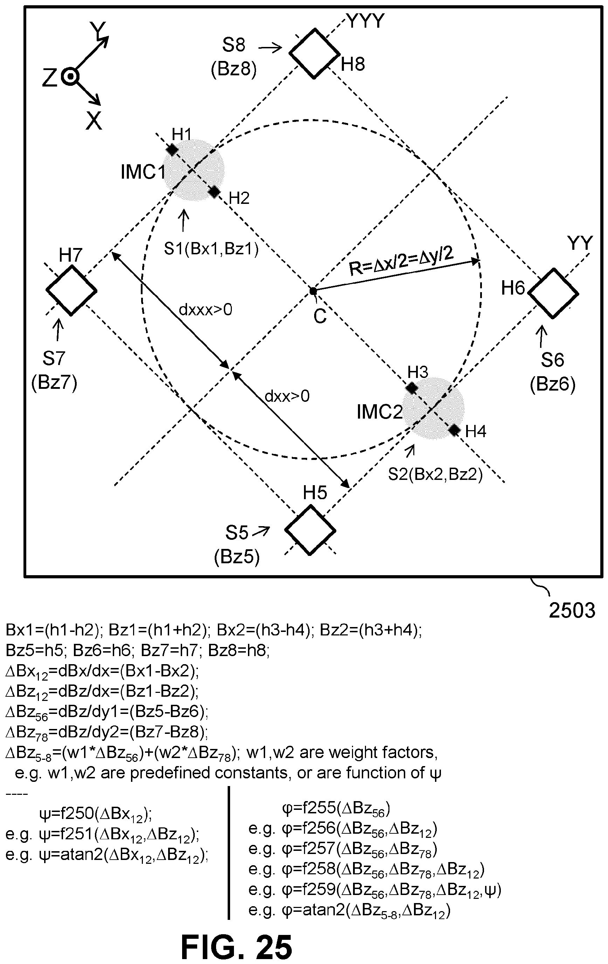

In an embodiment, each of the first and the second magnetic sensor comprises an integrated magnetic flux concentrators (IMC) and two horizontal Hall elements angularly spaced apart by 180°, and the third and fourth magnetic sensor (S5, S6) are horizontal Hall elements without IMC. Optionally the substrate further comprises a fifth and a sixth magnetic sensor, e.g. as illustrated in FIG. 25.

In an embodiment, each of the first and second magnetic sensor (51, 52) is or comprises a vertical Hall element arranged for measuring a Bx component, and each of the third and the fourth magnetic sensor (S5, S6) is a horizontal Hall element, e.g. as illustrated in FIG. 25. Optionally each of the first and second sensor (51, 52) further comprises a horizontal Hall element.

The present invention also provides a sensor system comprising: a magnetic sensor device according to the third aspect; and said two-pole magnet.

The two-pole magnet is preferably magnetized in a direction parallel to the semiconductor substrate when the line segment [CP] is oriented substantially perpendicular to the semiconductor substrate (e.g. within a tolerance margin of $\pm 10°$ or $\pm 5°$).

In an embodiment, the sensor system comprises: a sensor device comprising: a semiconductor substrate comprising or connected to a plurality of magnetic sensors (e.g. 51,52; 51,52,53,54; 51,52,55,56) spaced apart from each other; the sensor device further comprising a processing circuit (e.g. implemented on the same semiconductor substrate, or on a second semiconductor substrate) configured for determining at least a first and a second magnetic field gradient, and for determining a first angle (e.g. $\alpha, \psi$) based on the first magnetic field gradient, and for determining a second angle (e.g. $\beta, \phi$) based on the second magnetic field gradient; a two-pole magnet, that is movable relative to the sensor device such that a centre (e.g. P) of the magnet is pivotable about a reference point (e.g. Pref) having a predefined position relative to the semiconductor substrate (e.g. in the plane of the semiconductor substrate, above the semiconductor substrate, or below the semiconductor substrate); wherein the magnet is magnetized in a direction parallel to the semiconductor substrate when a virtual line passing through the centre (e.g. P) of the magnet and through the reference point (e.g. Pref) is oriented perpendicular to the semiconductor substrate, or wherein an orthogonal projection of the centre (e.g. P) of the magnet upon the semiconductor substrate substantially coincides with a point (e.g. C) located in the middle between the first sensor (e.g. 51) and the second sensor (e.g. S2), or wherein the magnet is magnetized in a direction substantially perpendicular to a virtual line passing through the centre (e.g. P) of the magnet and through the reference point (e.g. Pref).

In an embodiment, the plurality of magnetic sensors comprises two sensors (e.g. 51, S2) spaced apart along a first direction (e.g. X), wherein each of the sensors is capable of measuring at least two magnetic field components.

In an embodiment, the plurality of magnetic sensors comprises four sensors (e.g. 51,52,53,54; 51,52,55,56), including a first and a second sensor (e.g. 51, S2) spaced apart along a first direction (e.g. X), and including a third and a fourth sensor (e.g. 53,54; S5, S6) spaced apart in a second direction (e.g. Y), wherein each of the four sensors is capable of measuring at least one magnetic field component.

In an embodiment, the plurality of magnetic sensors comprise magnetic sensor elements selected from the group consisting of horizontal or vertical Hall elements.

In an embodiment, the plurality of magnetic sensors comprise magnetic sensor elements being horizontal Hall elements.

In an embodiment, the plurality of magnetic sensors comprise magnetic sensor elements being vertical Hall elements.

In an embodiment according to any of the first, second, third or fourth aspect, the sensor device comprises at least one cmos substrate, (i.e. a semiconductor substrate that is produced with a cmos compatible process).

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

**Brief description of the drawings**

FIG. 1 is a schematic representation of a magnetic position sensor system comprising a magnet which is pivotable relative to a sensor device with two degrees of freedom.

FIG. 2 shows how a random orientation of a line segment [CP] can be represented by two angles, for example $\psi$ and $\phi$, or $\alpha$ and $\beta$.

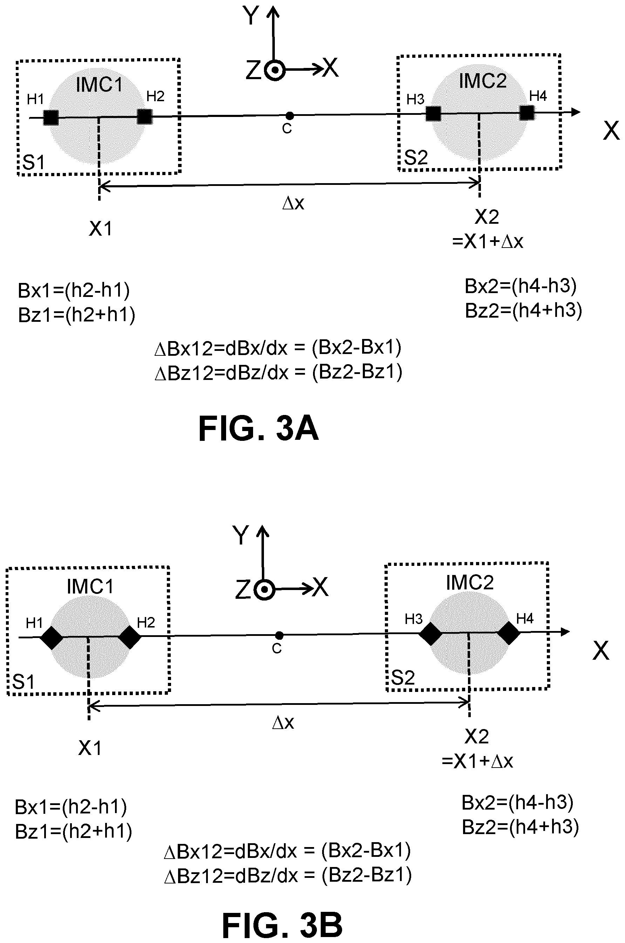

FIG. 3A is a schematic block diagram of sensor structure as may be used in embodiments of the present invention. The sensor structure comprises two magnetic sensors, spaced apart along an X-axis by a predefined distance $\Delta x$, each magnetic sensor comprising an integrated magnetic concentrator (IMC) and two horizontal Hall elements located on the X-axis.

FIG. 3B shows a variant of the sensor structure of FIG. 3A, and may be used in embodiments of the present invention.

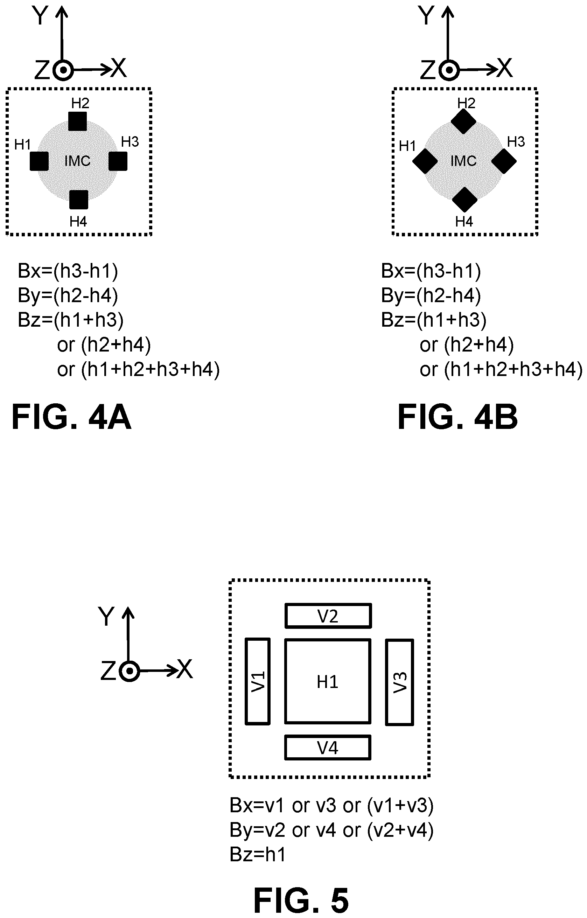

FIG. 4A is a schematic block-diagram of a sensor structure as may be used in embodiments of the present invention. The sensor structure comprises a disk shaped integrated magnetic concentrator (IMC) and four horizontal Hall elements situated at a periphery of the disk, angularly spaced by multiples of 90°. This sensor structure is capable of measuring 3 orthogonal magnetic field components, and is also referred to as a "3D magnetic pixel".

FIG. 4B shows a variant of the sensor structure of FIG. 4A, and may be used in embodiments of the present invention.

FIG. 5 is a schematic block-diagram of another sensor structure as may be used in embodiments of the present invention. This sensor structure comprises a horizontal Hall element and four vertical Hall elements, arranged near the periphery of the horizontal Hall element. This sensor structure is also capable of measuring 3 orthogonal magnetic field components, and is therefore also a "3D magnetic pixel".

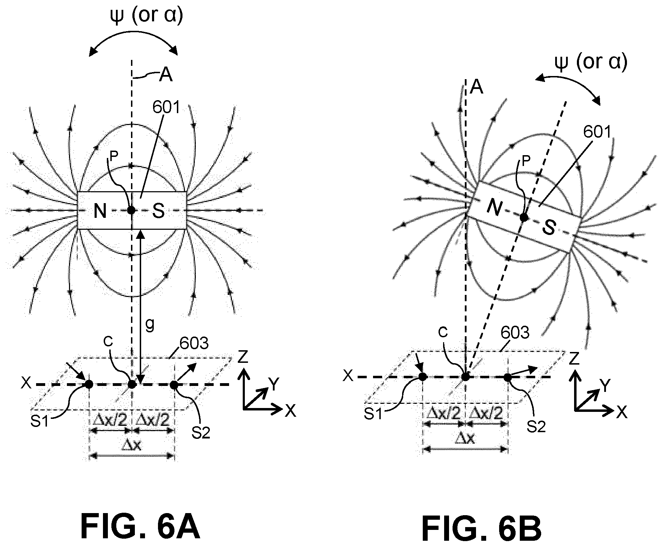

FIG. 6A is a schematic representation of a cylindrical magnet having an axis that is substantially parallel with a semiconductor substrate when the magnet is in its "rest position" or "neutral position" (at which $\psi=0°$ and $\phi=0°$). FIG. 6A and FIG. 6B also give an impression of the magnetic field lines passing at a first sensor location S1 and a second sensor location S2 for $\psi=0°$ (FIG. 6A) and for $\psi=30°$ (FIG. 6B).

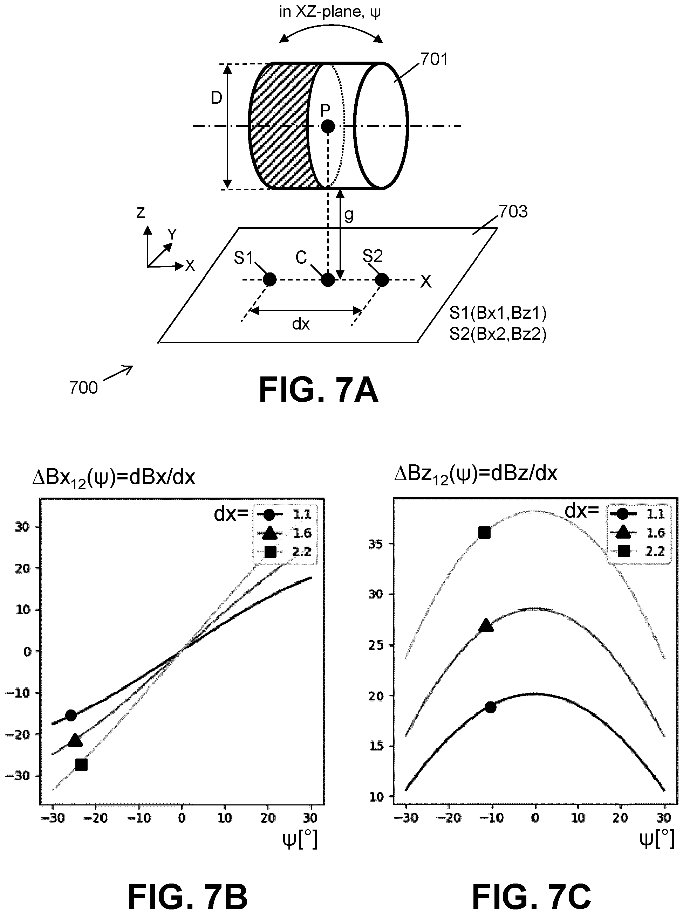

FIG. 7A shows an enlarged 3D perspective view of a sensor system like the one shown in FIG. 6A, without magnetic field lines. FIG. 7B show simulation results illustrating how the magnetic field gradient dBx/dx varies as a function of $\psi$, for different values of dx. FIG. 7C show simulation results illustrating how the magnetic field difference $\Delta Bz$ or gradient dBz/dx varies as a function of $\psi$, for different values of dx.

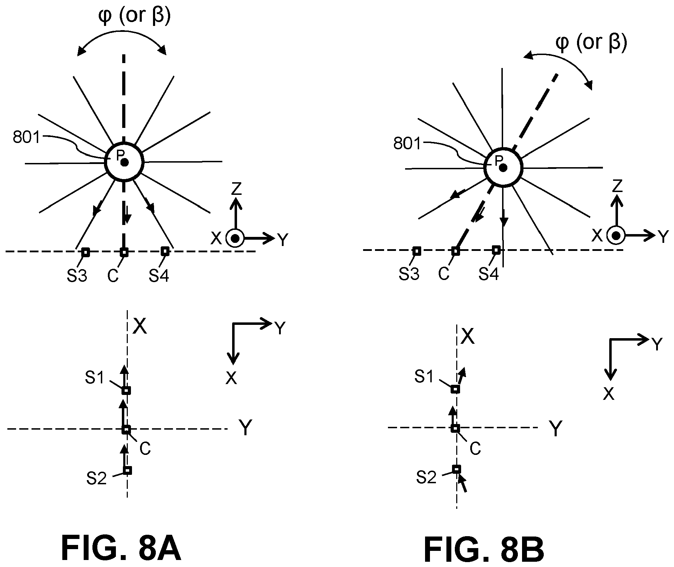

FIG. 8A (top) shows a side view in the X-direction of FIG. 6A, and FIG. 8A (bottom) shows a top view on the semiconductor substrate of FIG. 6A when the magnet is in its "neutral position". An impression of the magnetic field vector is shown at several positions in the substrate (not necessarily all sensed by a magnetic sensor).

FIG. 8B (top) shows a side view in the X-direction of FIG. 6B, and FIG. 8B (bottom) shows a top view on the semiconductor substrate of FIG. 6B when the magnet is tilted by $\phi=30°$. An impression of the magnetic field vector is shown at several positions in the substrate (not necessarily all sensed by a magnetic sensor).

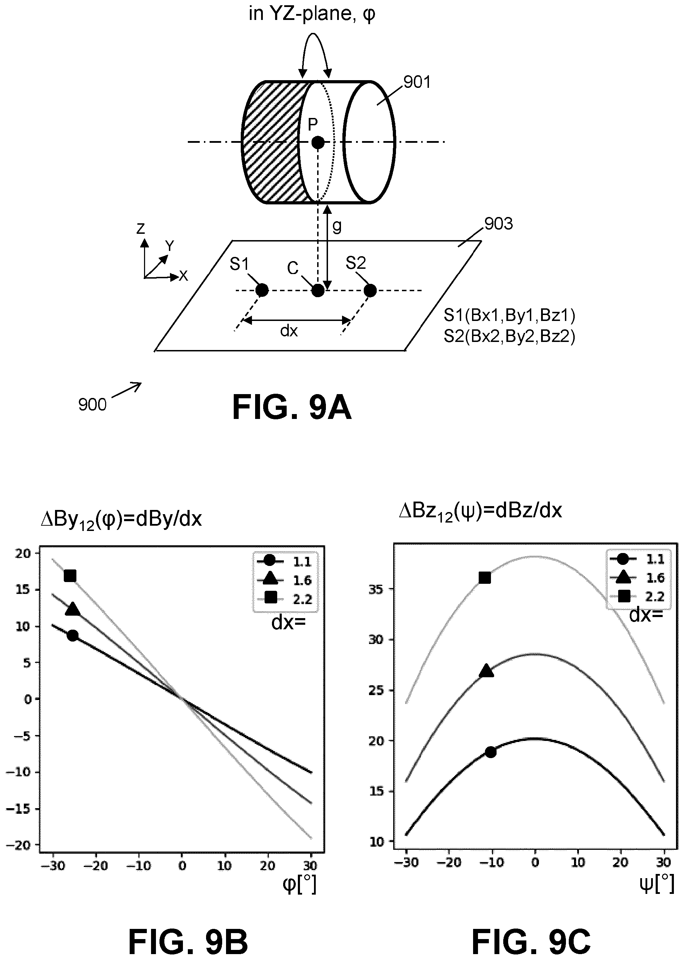

FIG. 9A shows an enlarged 3D perspective view of a sensor system like the one shown in FIG. 8A, without magnetic field lines. FIG. 9B show simulation results illustrating how the magnetic field gradient dBy/dx varies as a function of $\phi$, for different values of dx. FIG. 9C show simulation results illustrating how the magnetic field gradient dBz/dx varies as a function of $\phi$, for different values of dx.

FIG. 10A is a schematic representation of a sensor arrangement (referred to as "dual disk") as can be used in embodiments of the present invention, e.g. in the sensor device of FIG. 1, and a set of formulas for determining the orientation of the magnet as a function of $\Delta Bx12$ (or dBx/dx) for determining a first angle $\psi$, and as a function of $\Delta By12$ (or dBy/dx) for determining a second angle $\phi$.

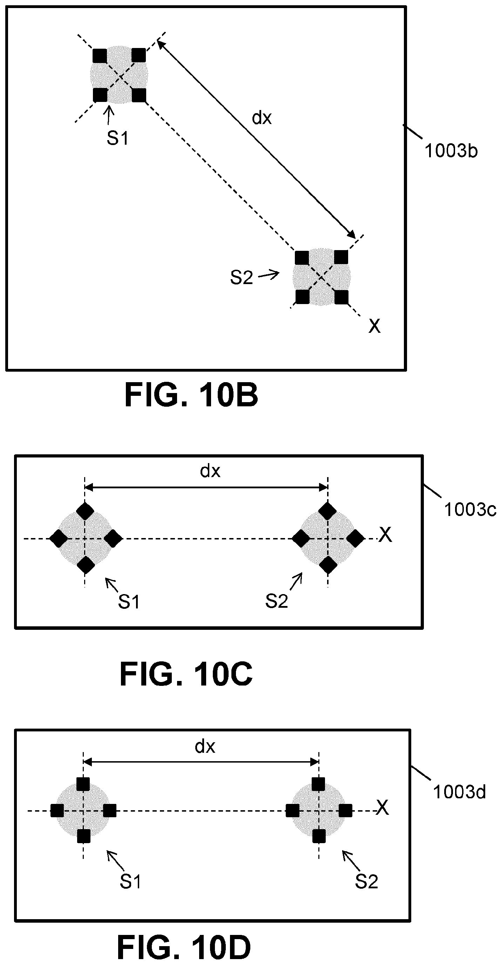

FIG. 10B to FIG. 10D show several variants of FIG.

10A, to illustrate that the two disks do not necessarily need to be located near the corners of the semiconductor substrate, and to demonstrate that the orientation of the Hall plates may be rotated relative to the semiconductor substrate.

**FIG. 11** is a schematic representation of another sensor arrangement as can be used in embodiments of the present invention, comprising two 3D magnetic pixels, each having a horizontal Hall element and four vertical Hall elements.

**FIG. 12** shows a variant of FIG. 11, as can be used in embodiments of the present invention, comprising two 2D magnetic pixels, and further comprising a temperature sensor.

**FIG. 13** shows another variant of FIG. 11, as can be used in embodiments of the present invention, comprising two 2D magnetic pixels, and a 3D magnetic pixel between them.

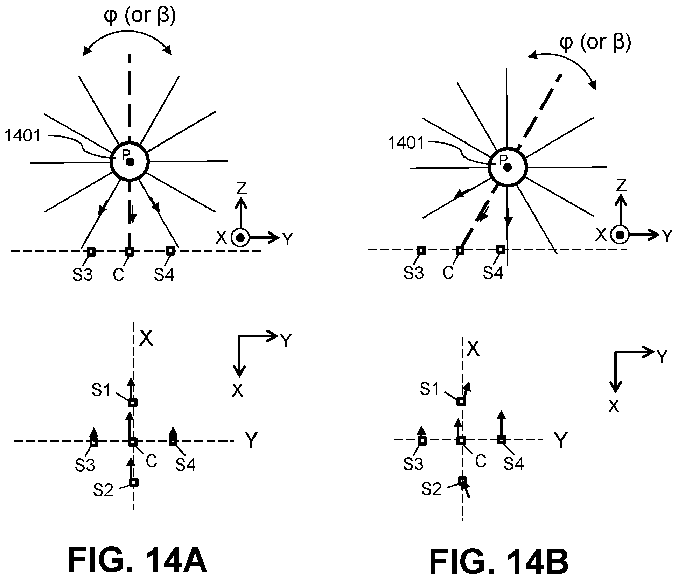

**FIG. 14A** shows a variant of FIG. 8A, with a qualitative impression of magnetic field vectors at five different locations.

**FIG. 14B** shows a variant of FIG. 8B, with a qualitative impression of magnetic field vectors at five different locations.

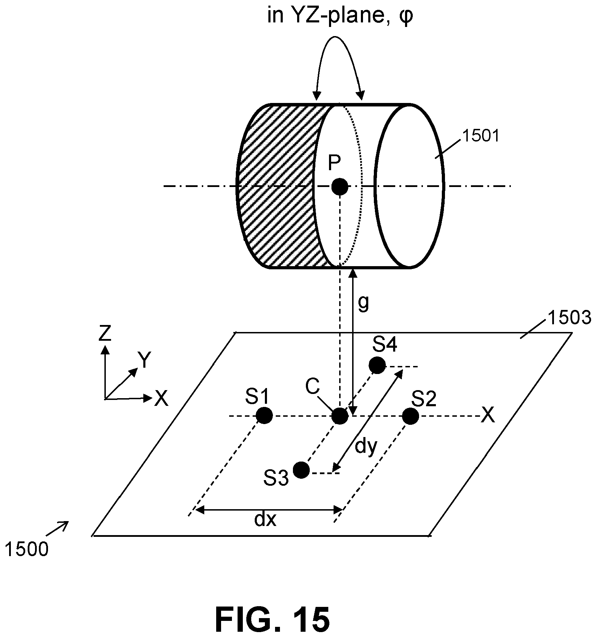

**FIG. 15** shows an enlarged 3D perspective view of FIG. 9A.

**FIG. 16** is a schematic representation of a sensor arrangement as can be used in embodiments of the present invention, e.g. in the sensor device of FIG. 1, and a set of formulas for determining the orientation of the magnet as a function of $\Delta Bx12$ (or dBx/dx) for determining a first angle $\psi$, and as a function of $\Delta Bx34$ (or dBx/dy) for determining a second angle $\phi$. This sensor arrangement comprises two 2D magnetic pixels on the X-axis, and two 1D-magnetic pixels on the Y-axis.

**FIG. 17** shows a variant of FIG. 16, as can be used in embodiments of the present invention, also comprising two 2D magnetic pixels on the X-axis, and two 1D-magnetic pixels on the Y-axis.

**FIG. 18** shows another variant of FIG. 16, as can be used in embodiments of the present invention, comprising four 2D magnetic pixels.

**FIG. 19** shows another variant of FIG. 16, as can be used in embodiments of the present invention, comprising four 1D magnetic pixels, and optionally a temperature sensor.

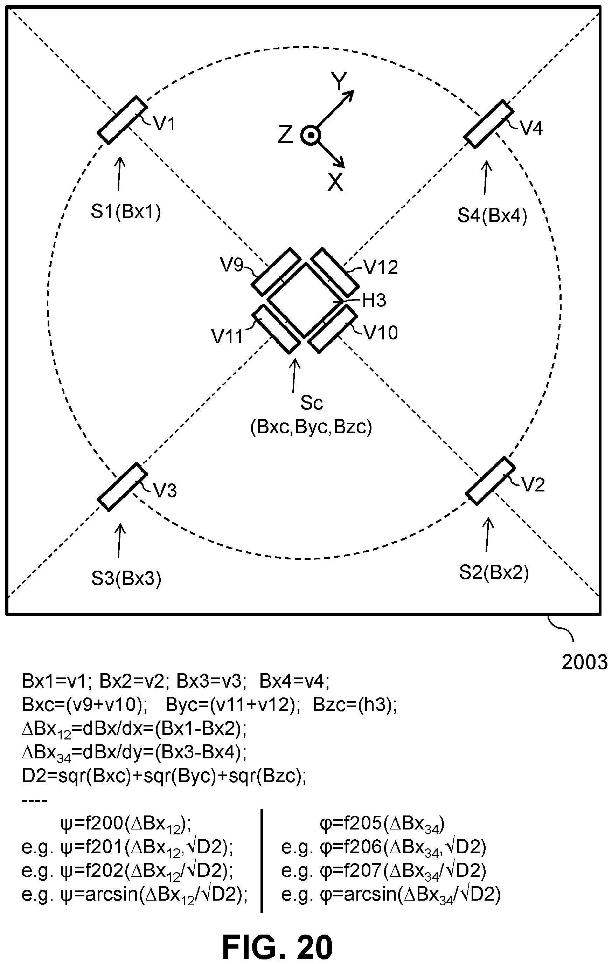

**FIG. 20** shows another variant of FIG. 16, as can be used in embodiments of the present invention, comprising four 1D magnetic pixels and a 3D magnetic pixel between them.

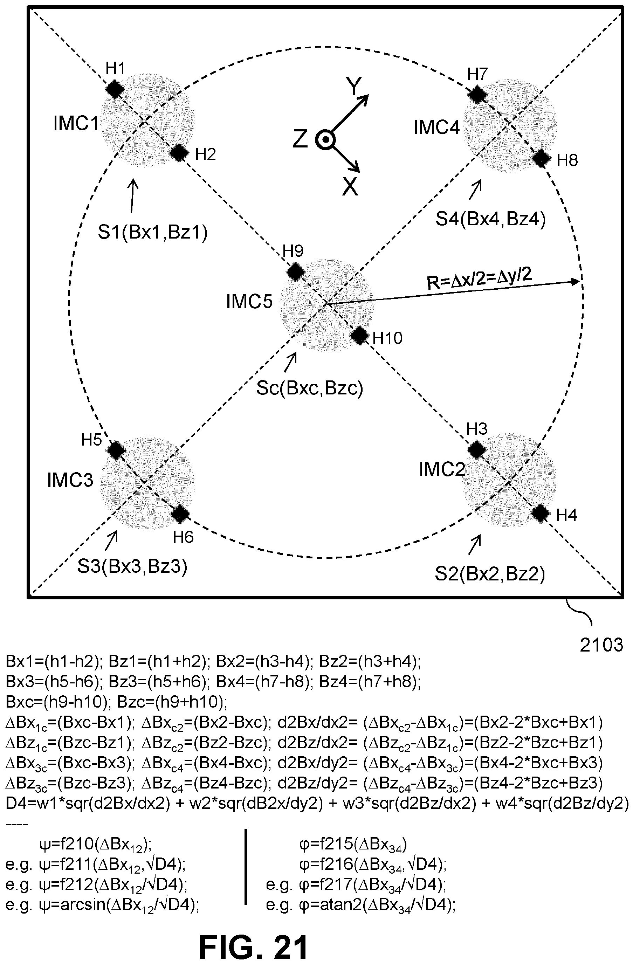

**FIG. 21** shows another variant of FIG. 16, as can be used in embodiments of the present invention, comprising five 2D magnetic pixels.

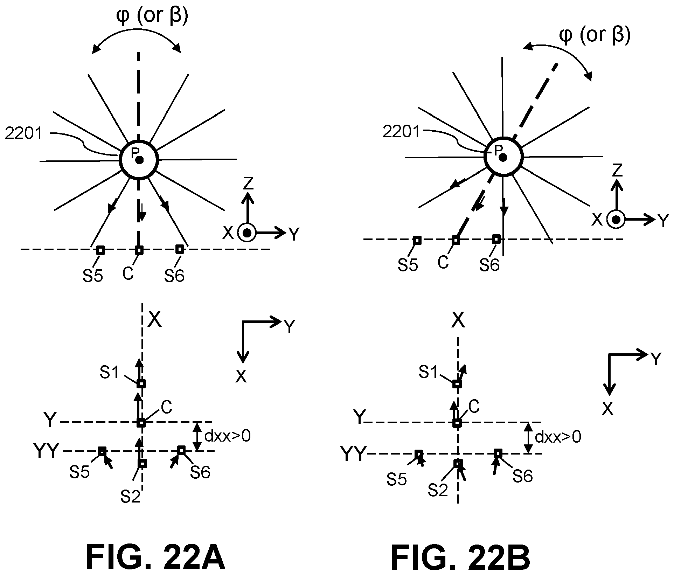

**FIG. 22A** shows the same information as FIG. 8A.

**FIG. 22B** is a variant of FIG. 8B, furthermore giving an impression of the magnetic field vector at sensor locations S5, S6 located on a line YY parallel to Y, but offset from Y by a distance dxx>0.

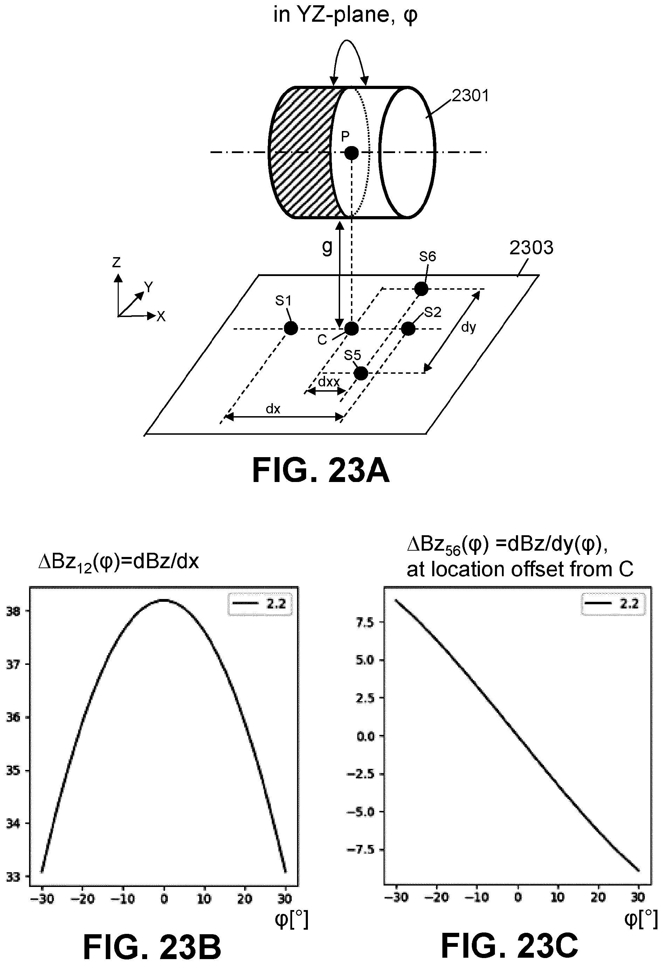

**FIG. 23A** is a variant of FIG. 15 and a 3D perspective view on a special case of FIG. 22B, wherein dxx= (dx/2), such that the line YY passes through S2.

**FIG. 23B** shows simulation results illustrating how the magnetic field gradient dBz/dx varies as a function of $\phi$.

**FIG. 23C** shows simulation results illustrating how the magnetic field difference measured at the sensor locations S5, S6 (or the gradient dBz/dy at a position offset from C) varies as a function of $\phi$.

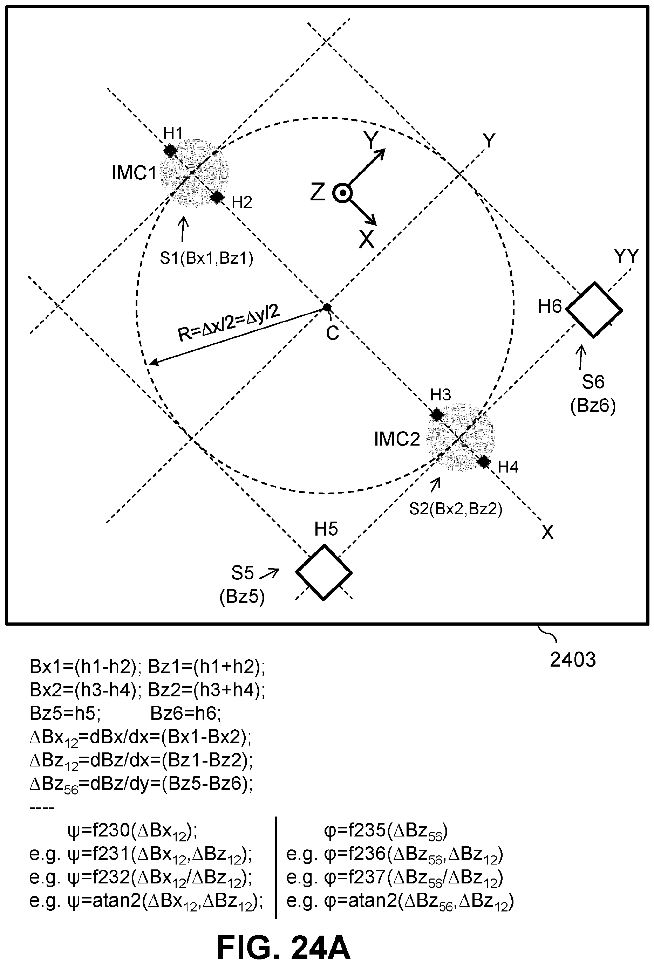

**FIG. 24A** is a schematic representation of a sensor arrangement as can be used in embodiments of the present invention, using magnetic field components measured at four sensor locations 51, S2, S5, S6 shown in FIG. 23A, and shows a set of formulas for determining the orientation of the magnet as a function of $\Delta Bx12$ (or dBx/dx) for determining a first angle $\psi$, and as a function of $\Delta Bz56$ (or dBz/dy at a position offset from C) for determining a second angle $\phi$.

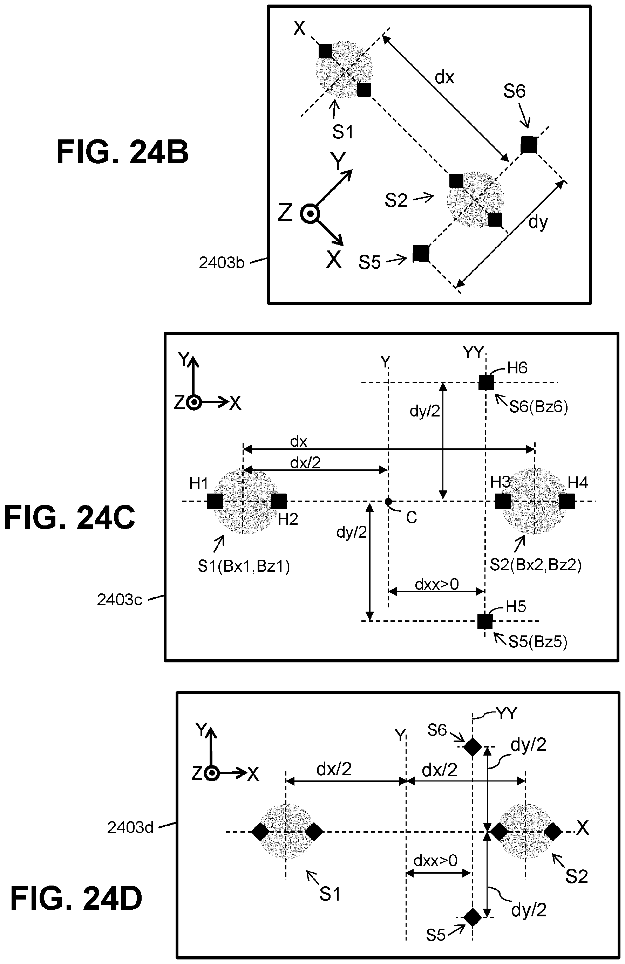

**FIG. 24B to FIG. 24D** show several variants of FIG. 24A, to illustrate that the two IMC disks do not necessarily need to be located near the corners of the semiconductor substrate, and to demonstrate that the orientation of the Hall plates may be rotated relative to the semiconductor substrate.

**FIG. 25** shows a variant of FIG. 24A, as can be used in embodiments of the present invention, comprising two 2D magnetic pixels on the X-axis, and four horizontal Hall elements located on a virtual square.

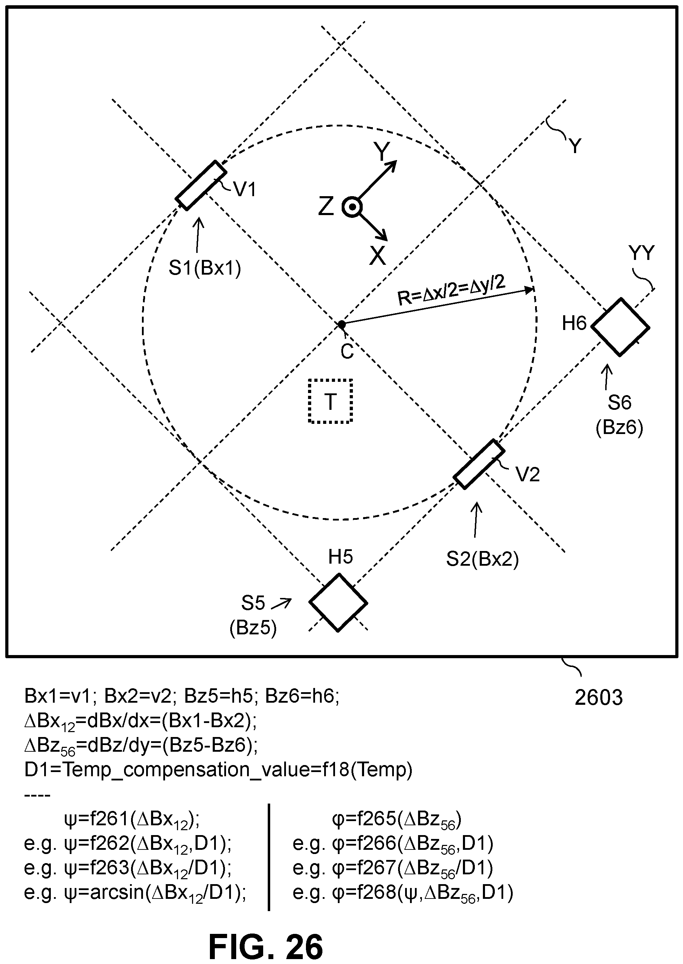

**FIG. 26** shows another variant of FIG. 24A, as can be used in embodiments of the present invention, comprising two vertical Hall elements on the X-axis, and two horizontal Hall elements on a YY-axis perpendicular to the X-axis, but offset from the point C in the middle between S1 and S2. This sensor device further comprises a temperature sensor.

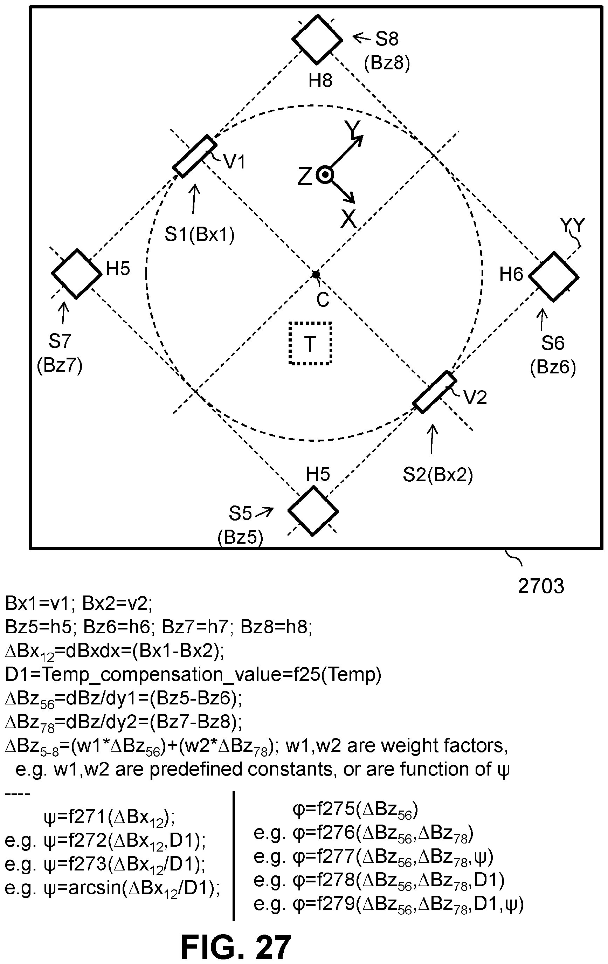

**FIG. 27** shows another variant of FIG. 24A, as can be used in embodiments of the present invention, comprising two vertical Hall elements on the X-axis, and four horizontal Hall elements located on a virtual square. This sensor device further comprises a temperature sensor.

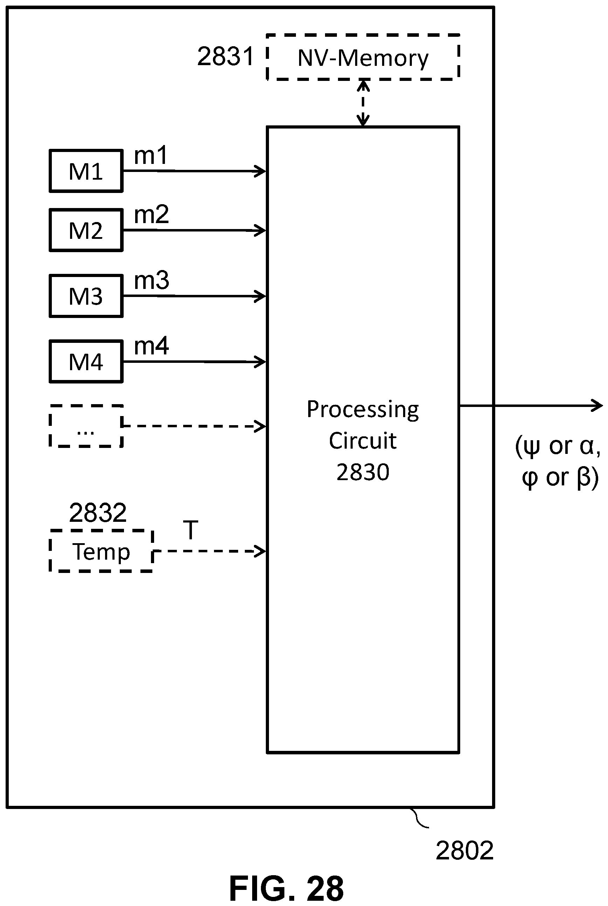

**FIG. 28** shows an electrical block-diagram of a circuit that may be used in sensor devices proposed by the present invention.

The drawings are only schematic and are non-limiting. In the drawings, the size of some of the elements may be exaggerated and not drawn on scale for illustrative purposes. Any reference signs in the claims shall not be construed as limiting the scope. In the different drawings, the same reference signs refer to the same or analogous elements.

**Detailed description of illustrative embodiments**

The present invention will be described with respect to particular embodiments and with reference to certain drawings but the invention is not limited thereto but only by the claims.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

The terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

In this document, unless explicitly mentioned otherwise, the term "magnetic sensor device" or "sensor device" refers to a device comprising at least one "magnetic sensor" or at least one magnetic "sensor element", preferably integrated in a semiconductor substrate. The sensor device may be comprised in a package, also called "chip", although that is not absolutely required.

In this document, the term "sensor element" or "magnetic sensor element" or "magnetic sensor" can refer to a component or a group of components or a sub-circuit or a structure capable of measuring a magnetic quantity, such as for example a magneto-resistive (MR) element, a GMR element, an XMR element, a horizontal Hall plate, a vertical Hall plate, a Wheatstone-bridge containing at least one (but preferably four) magneto-resistive elements, etc. or combinations hereof.

In embodiments of the present invention, the term "magnetic sensor" or "magnetic sensor structure" may refer to an arrangement comprising one or more integrated magnetic concentrators (IMC), also known as integrated flux concentrators, and one or more horizontal Hall elements arranged near the periphery of the IMC, for example a disk shaped IMC with four horizontal Hall elements angularly spaced by multiples of 90°.

In this document, the expression "2D magnetic sensor" or "2D magnetic pixel" mean the same.

In this document, the expression "3D magnetic sensor" or "3D magnetic pixel" mean the same.

In this document, the expression "in-plane component of a magnetic field vector" and "projection of the magnetic field vector in the sensor plane" mean the same. If the sensor device is or comprises a semiconductor substrate, this also means a "magnetic field component parallel to the semiconductor plane". These components may be labelled Bx, By.

In this document, the expression "out-of-plane component of a magnetic field vector" and "Z component of the vector" and "projection of the vector on an axis perpendicular to the sensor plane" mean the same. This component may be labelled Bz.

Embodiments of the present invention are typically described using an orthogonal coordinate system which is fixed to the sensor device, and having three axes X, Y, Z, where the X and Y axis are parallel to the substrate, and the Z-axis is perpendicular to the substrate.

In this document, the expression "spatial derivative" or "derivative" or "spatial gradient" or "gradient" are used as synonyms. If the order of the derivative is not explicitly mentioned, a first order gradient is meant, unless clear from the context otherwise. In the context of the present invention, the gradient is typically determined as a difference between two values measured at two locations spaced apart along a certain direction. In theory the gradient is typically calculated as the difference between two values divided by the distance between the sensor locations (e.g. dx), but in practice the division by said distance is often omitted, because the measured signals need to be scaled anyway. Hence, in the context of the present invention, the expression "magnetic field difference" and "magnetic field gradient" can be used interchangeably.

In this application, horizontal Hall plates are typically referred to by H1, H2, etc., signals obtained from horizontal Hall plates are typically referred to by h1, h2, etc., vertical Hall plates are typically referred to by V1, V2, etc., and signals from vertical Hall plates are typically referred to by v1, v2, etc.

In the context of the present invention, the formulas arctan(x/y), atan2(x,y), arccot(y/x) are considered to be equivalent.

The function atan2() is the two-argument arctangent function. The function sqr() is the square function. The function sqrt(.) is the square root function.

The function atan2 is the two-argument arctangent function, known in the art.

Unless clear from the context otherwise, in this document $\Delta x$ and dx mean the same.

In this document, S1 can mean the first sensor location or the first magnetic sensor, depending on the context. Likewise for S2, S3, S4, S5, S6. In the context of the present invention, S1 and S2 are located on the X-axis; S3 and S4 are located on the Y-axis perpendicular to the X-axis and passing through the point C in the middle between S1 and S2; and S5 and S6 are located on an axis YY perpendicular to the X-axis but offset from the Y-axis by a distance dxx>0. The distance dxx can be larger than, equal to, or smaller than (dx/2). The distance between S3 and S4, and the distance between S5 and S6 is indicated by "dy". The value of dy may be larger than, equal to dx, or smaller than dx.

The present invention is related to magnetic position sensor devices and systems for measuring an orientation of a magnet which is pivotable about a fixed reference point "Pref". This fixed reference point may be located on a semiconductor substrate, or may be located at a predefined distance above or below a semiconductor substrate. In the drawings of the present invention, the fixed reference point Pref is typically shown to be located in the semiconductor substrate for illustrative purposes, (and coinciding with the point C in the middle between the first and second sensor location S1, S2), but it is explicitly pointed out that the present invention is not limited thereto.

It is also noted that mechanical assemblies configured for allowing such magnet movements are known in the art, and hence need not be described in detail here.

In preferred embodiments, the system has one or more or all of the following characteristics: good or improved accuracy, low or reduced sensitivity to temperature variations, low or reduced sensitivity to mounting tolerances, low or reduced sensitivity to demagnetization of the magnet, low or reduced sensitivity to an external disturbance field, and preferably all of these.

Referring to the Figures.

**FIG. 1** is a schematic representation of a magnetic position sensor system 100 comprising a two-pole magnet 101, and a sensor device 102.

The sensor device 102 comprises a semiconductor substrate (not shown in FIG. 1). A coordinate system with three orthogonal axis X, Y, Z is connected to the semiconductor substrate, such that the axes X and Y are parallel to the semiconductor substrate, and the axis Z is orthogonal to the semiconductor substrate.

The magnet is movable relative to the sensor device 102 such that a centre (P) of the magnet is pivotable about a reference point (Pref) having a predefined position relative to the semiconductor substrate. The sensor device 102 comprises a semiconductor substrate, e.g. a silicon substrate produced via a CMOS-compatible process. The reference point Pref may be located in the plane of the semiconductor substrate, above the semiconductor substrate, or below the semiconductor substrate, but in order not to complicate the drawings, the reference point is shown to be located in the semiconductor substrate, and to coincide with a point "C".

The magnet 101 shown in FIG. 1 is a two-pole magnet having a cylindrical shape, but other shapes may also be used, e.g. the magnet may be a two-pole bar magnet or a two-pole spherical magnet. The magnet 101 is magnetized along an axis that is oriented parallel to the semiconductor substrate when the magnet is in its "neutral position", i.e. when a centre of the magnet P is situated orthogonally above the point C. The distance between the magnet 101 and the reference point "Pref" is constant, and the system has two degrees of freedom. The task of the sensor device 102 is to determine the orientation of the magnet 101.

The orientation can be uniquely defined for example by means of two angles $\phi$ and $\psi$, where $\phi$ is a negative or positive angle with respect to the Z-axis of an orthogonal projection of the line segment [CP] in the YZ-plane, and $\psi$ is a negative or positive angle with respect to the Z-axis of an orthogonal projection of the the line segment [CP] in the XZ-plane. When the magnet is in the "neutral position", $\phi=0°$ and $\psi=0*$. The magnet is preferably movable at least in the range $\phi$ from -30° to +30°, and in the range $\psi$ from -30° to +30°, but of course smaller or larger ranges are also envisioned. But specifying the orientation by means of $\phi$ and $\psi$ is not the only possible way.

FIG. 2 shows another way of defining the orientation of a vector of a constant length [CP] starting from the reference point "C", and ending at a point "P" on an imaginary sphere. The vector [CP] is not shown, but a first orthogonal projection [CA] of the vector [CP] onto the plane XZ is shown, and a second orthogonal projection [CB] of the vector [CP] onto the plane YZ is shown. The position of the magnet can also be defined by a first angle $\alpha$ between the positive X-axis and the vector [CA], and by a second angle $\beta$ between the positive Y-axis and the vector [CB]. As an example, if the magnet axis is oriented perpendicular to the plane XY (i.e. perpendicular to the semiconductor substrate), also referred to as the "neutral position", $\alpha=90°$ and $\beta=90°$. This corresponds to the orientation in which $\phi=0°$ and $\psi=0°$, described above.

The following formulas apply:

$$Bx = B * \cos(\alpha) * \sin(\beta) \qquad [1]$$

$$By = B * \cos(\beta) * \sin(\alpha) \qquad [2]$$

$$Bz = B * \sin(\beta) * \sin(\alpha) \qquad [3]$$

Division of [3] and [1] yields:

$$(Bz/Bx) = \tan(\alpha) \qquad [4]$$

$$(Bz/By) = \tan(\beta) \qquad [5]$$

where Bx is the magnetic field component oriented in the X-direction, By is the magnetic field component oriented in the Y-direction, Bz is the magnetic field component oriented in the Z-direction, and B is the magnitude of the magnetic field vector. Thus, by measuring Bx, By, Bz, at the reference point Pref, the angles $\alpha$ and $\beta$ can be calculated, but this solution is quite sensitive to external influences and/or ageing effect, e.g. to temperature variations, mounting tolerances, demagnetization of the magnet, an external disturbance field, etc.

In preferred embodiments, the angles $\alpha$ and $\beta$ are values in the range from 90° ± 30°, or in the range from 90° ± 40°, or in the range from 90° ± 50°, or in the range from 90°± 60°.

FIG. 3A is a schematic block diagram of sensor structure as may be used in embodiments of the present invention. The sensor structure comprises two magnetic sensors 51, 52, spaced apart along an X-axis by a predefined distance $\Delta x$. Each magnetic sensor comprising an integrated magnetic concentrator (IMC) and two horizontal Hall elements located on the X-axis.

Formulas are provided to calculate the two orthogonal magnetic field components Bx1, Bz1, Bx2, Bz2 from the sensor signals h1, h2, h3, h4 provided by the horizontal Hall elements H1, H2, H3, H4 respectively. It is noted that, in practice, the signals obtained from the Hall elements are amplified or scaled in known manners, but the scaling factor is omitted here to keep the explanation simple.

From the component values Bx1, Bx2 a magnetic field difference $\Delta Bx12 = (Bx2-Bx1)$ or a magnetic field gradient dBx/dx can be derived. From the component values Bz1, Bz2 a magnetic field difference $\Delta Bz12 = (Bz2-Bz1)$ or a magnetic field gradient dBz/dx can be derived. The gradients are highly insensitive to an external magnetic disturbance field. It is noted that division by the distance dx is typically omitted, because the signals need to be scaled anyway. Nevertheless the notation dBz/dx is handy because it makes clear that a component Bz (oriented in the Z-direction) is measured at two locations which are spaced apart by distance dx in the X-direction. The gradient dBz/dx is therefore referred to as a "magnetic field gradient of a Bz-component along the X-direction".

In embodiments of the present invention, the value of dx may be a value in the range from 1.0 mm to 3.0 mm, or from 1.5 mm to 2.5 mm. The IMC may have a disk shape with a diameter in the range from 150 $\mu$m to 250 $\mu$m, e.g. in the range from 170 $\mu$m to 230 $\mu$m, for example equal to about 200 $\mu$m. The horizontal Hall elements may have a substantially square shape with a length and a width in the range from about 15 $\mu$m to about 25 $\mu$m.

FIG. 3B shows a variant of the sensor structure of FIG. 3A as may be used in embodiments of the present invention, wherein the Hall elements are rotated by 45° with respect to those of FIG. 3A. The same formulas apply.

FIG. 4A is a schematic block-diagram of a sensor structure 300, as may be used in embodiments of the present invention. The sensor structure comprises a disk shaped integrated magnetic concentrator IMC and four horizontal Hall elements H1 to H4 situated at a periphery of the disk, angularly spaced by multiples of 90°. This sensor structure is capable of measuring 3 orthogonal magnetic field components at the centre of the IMC disk and is also referred to as a "3D magnetic pixel". Formulas are provided to calculate the three orthogonal magnetic field components Bx, By, Bz from the sensor signals h1, h2, h3, h4 provided by the horizontal Hall elements H1, H2, H3, H4 respectively. It is noted that, in practice, the signals obtained from the Hall elements are amplified or scaled in known manners, but the scaling factor is omitted here to keep the explanation simple.

FIG. 4B shows a variant of the sensor structure of FIG. 4A as may be used in embodiments of the present invention, wherein the Hall elements are rotated by 45° with respect to those of FIG. 4A. The same formulas apply.

**FIG. 5** is a schematic block-diagram of another sensor structure as may be used in embodiments of the present invention. This sensor structure comprises a horizontal Hall element H1 and four vertical Hall elements V1 to V4, arranged near the periphery of the horizontal Hall element. This sensor structure is also capable of measuring 3 orthogonal magnetic field components Bx, By, Bz at the centre of H1, and is therefore also referred to as a "3D magnetic pixel". Formulas are provided to calculate the three orthogonal magnetic field components Bx, By, Bz from the sensor signals h1, v1, v2, v3, v4 provided by the horizontal Hall element H1 and the vertical Hall elements V1, V2, V3, V4 respectively. It is noted that, in practice, the signals obtained from the Hall elements are amplified or scaled in known manners, but the scaling factor is omitted here to keep the explanation simple.

It is noted that it is not absolute required to use four vertical Hall elements in order to measure Bx and By, but more accurate results may be obtained by summing or averaging the signals (v1 and v3) to calculate Bx, and by summing or averaging the signals (v2 and v4) to calculate By.

**FIG. 6A** is a schematic representation of a cylindrical magnet 601 having an axis that is oriented substantially parallel with a semiconductor substrate 603, when the magnet is in its "rest position" or "neutral position" (at which $\psi=0°$ and $\phi=0°$).

**FIG. 6A** also gives an impression of the magnetic field lines at a first sensor location S1 and at a second sensor location S2, schematically indicated by black dots. A point C in the middle between these two sensor locations 51, 52 is also indicated. In some embodiments of the present invention, there may also be a magnetic sensor situated at the point C, but that is not absolutely required. When the magnet 601 is in its neutral position (as illustrated in FIG. 6A), the line segment [CP] is oriented perpendicular to the semiconductor substrate, hence an orthogonal projection of the centre P of the magnet onto the substrate 603 coincides with the point C.

**FIG. 6B** gives an impression of the magnetic field lines at a first sensor location S1 and at a second sensor location S2, when the magnet is rotated in the XZ plane, such that the line segment [CP] forms an angle of about 30° with the X-axis. By comparing FIG. 6A and FIG. 6B, it can be appreciated that the flux lines at S1 and S2 vary as a function of $\psi$ (or $\alpha$), but it is impossible for a normal human being to predict how this function would look like.

**FIG. 7A** shows an enlarged 3D perspective view of a sensor system like the one shown in FIG. 6A, but without showing the magnetic field lines.

Computer simulations were performed for a cylindrical magnet 701 having a diameter of 4.0 mm, and a height of 4.0 mm, situated at a distance "g" of 3.0 mm between the substrate and the magnet, for various distances dx between the two sensor locations 51, 52, namely for dx=1.1 mm, dx=1.6 mm, and dx=2.2 mm, to determine how the magnetic field difference $\Delta Bx12=(Bx2-Bx1)$, also referred to as dBx/dx would vary as a function of $\psi$. The result is shown in **FIG. 7B**.

Thus, by storing this relationship for a particular value of dx in the sensor device, and by measuring the value of Bx1 and Bx2, the angle $\psi$ can be determined. The relationship can be stored in any suitable manner, for example by means of a mathematical formula, or a lookup table in a non-volatile memory. Such a solution (in which $\psi$ is determined based solely on dBx/dx) works well in an environment where the temperature is relatively constant. Thus, for certain applications, such a solution is sufficiently accurate.

In applications where a higher accuracy is required, e.g. in industrial or robotic or automotive applications, some kind of correction may be needed to make the result less dependent on temperature variations, and/or less dependent on mounting tolerances (e.g. larger or smaller value of "g"), and/or less dependent on ageing effects (such as demagnetization). Several solutions will be described, e.g. using a second gradient dBz/dx, or using a correction value D1 as a function of temperature, or using a correction value D2 indicative of the norm of the magnetic field, or using a correction value D3 indicative of the norm of the gradient field, or using a correction value D4 based on one or more second order gradients.

**FIG. 7C** show simulation results illustrating how the magnetic field difference $\Delta Bz12=Bz2-Bz1$ or magnetic field gradient dBz/dx varies as a function of $\psi$, for different values of dx. A solution based on both dBx/dx and dBz/dx will be described in more detail further (see e.g. FIG. 10A), but other solutions are provided as well, (see e.g. FIG. 11 to FIG. 13).

Thus, the first angle $\psi$ can be determined based on dBx/dx, but the inventors also needed to find a solution for determining $\phi$.

As far as the inventors are aware, FIG. 8A and FIG. 8B are not known in the art, but are based on the imagination of the inventors.

**FIG. 8A** (top) shows a side view (in the X-direction) of FIG. 6A, and

**FIG. 8A** (bottom) shows a top view on the semiconductor substrate of FIG. 6A when the magnet 801 is in its "neutral position" (i.e. $\psi=0°$ and $\phi=0°$). A qualitative impression of the magnetic field vectors as would be measured at several locations 51, 52, C on the substrate is also shown (if there are suitable sensors at these locations).

**FIG. 8B** (top) shows a side view (in the X-direction) of FIG. 6B, and

**FIG. 8B** (bottom) shows a top view on the semiconductor substrate of FIG. 6B when the magnet is tilted in the YZ-plane by $\phi=30°$. A qualitative impression of the magnetic field vectors as would be measured said locations 51, 52, C is also shown.

The inventors surprisingly found that the magnetic field vectors at S1 and S2 also change as a function

of $\phi$, especially the value of By1 and By2, without requiring other sensor locations. The inventors were especially surprised that it is possible to measure the angle $\phi$ using only two sensors located on the line X. This is highly counter-intuitive.

Solutions where the angle $\phi$ is derived from By1 and By2, or more specifically from (By2-By1) or dBy/dx, will be described further in FIG. 9A to FIG. 13.

**FIG. 9A** shows an enlarged 3D perspective view of a sensor system 900 similar to the one shown in FIG. 8A, without showing the magnetic field lines. The semiconductor substrate 903 comprises two 3D-magnetic pixels, each capable of measuring three orthogonal magnetic field components.

Computer simulations were performed for a cylindrical magnet 901 having a diameter of 4.0 mm, and a height of 4.0 mm, situated at a distance "g" of 3.0 mm between the substrate and the magnet, for various distances dx between the two sensor locations 51, 52, namely for dx=1.1 mm, dx=1.6 mm, and dx=2.2 mm, to determine how the magnetic field gradient $\Delta$By12= (By2-By1), also referred to as dBy/dx would vary as a function of $\phi$. The result is shown in **FIG. 9B.**

Thus, by storing this relationship for a particular value of dx in the sensor device, and by measuring the value of By1 and By2, the angle $\phi$ can be determined. The relationship can be stored in any suitable manner, for example by means of a mathematical formula, or a lookup table in a non-volatile memory. Such a solution (in which $\phi$ is determined based solely on dBy/dx) works well in an environment where the temperature is relatively constant. Thus, for certain applications, such a solution is sufficiently accurate.

In applications where a higher accuracy is required, e.g. in industrial or robotic or automotive applications, some kind of correction may be needed also for $\phi$. Again, several solutions will be described, e.g. using the second gradient dBz/dx (which is dependent on $\psi$), or using a correction value D1 as a function of temperature, or using a correction value D2 indicative of the norm of the magnetic field, or using a correction value D3 indicative of the norm of the gradient field, or using a correction value D4 based on one or more second order gradients.

**FIG. 9C** is a copy of FIG. 7C. A solution based on both dBy/dx and dBz/dx will be described in more detail further (see e.g. FIG. 10A), but other solutions are provided as well, (see e.g. FIG. 11 to FIG. 13).

Thus, the first angle $\psi$ can be determined based on dBx/dx, and the second angle $\phi$ can be determined based on dBy/dx. Embodiments of the invention based on this principle will be described in FIG. 10A to FIG. 13.

**FIG. 10A** is a schematic representation of a sensor arrangement (also referred to as "dual disk") as can be used in embodiments of the present invention, e.g. in the sensor device of FIG. 1, and shows a set of formulas for determining the orientation of the magnet as a function of $\Delta$Bx12 (or dBx/dx) for determining a first angle $\psi$, and as a function of $\Delta$By12 (or dBy/dx) for determining a second angle $\phi$.

**FIG. 10B, FIG. 10C** and **FIG. 10D** show several variants of FIG. 10A, to illustrate that the semiconductor substrate does not need to have a square shape, and that the two IMC disks do not necessarily need to be located near the corners of the semiconductor substrate, and to illustrate that the orientation of the Hall plates may be rotated relative to the semiconductor substrate. The same formulas mentioned in FIG. 10A are applicable.

**FIG. 11** is a schematic representation of another sensor arrangement 1103, which can be seen as a variant of the sensor arrangement of FIG. 10A.

The sensor arrangement 1103 comprises two 3D magnetic pixels, each having a horizontal Hall element and four vertical Hall elements. Formulas for determining a first angle $\psi$ and a second angle $\phi$ are provided.

In a variant of FIG. 11 (not shown), some of the vertical Hall elements are omitted. For example, V2 and V4 may be omitted from 51, and V5 and V8 may be omitted from S2, and the following formulas could be used: Bx1=v1; By1=v3; Bx2=v6; By2=v7.

The same remarks as described in FIG. 10A to FIG. 10D, e.g. regarding the location and orientation of the sensors relative to the semiconductor substrate, and the size and shape of the substrate are also applicable here, mutatis mutandis.

**FIG. 12** shows another variant of FIG. 11, comprising two 2D magnetic pixels, and optionally further comprising a temperature sensor. In this embodiment, the sensors S1 and S2 cannot measure Bz1 and Bz2, hence the sensor device cannot determine dBz/dx.

A temperature of the magnet may be measured using a temperature sensor (e.g. a thermocouple, or a thermistor, or a temperature dependent resistor) mounted to the magnet and electrically connected to the sensor device, or may be estimated using a temperature sensor "T" incorporated in the sensor device, e.g. embedded in the semiconductor substrate.

If the temperature sensor is not present, this sensor arrangement can be used to determine the first angle $\psi$ based on dBx/dx, and to determine the second angle $\phi$ based on dBy/dx, without compensation.

If the temperature sensor is present, a temperature can be measured, e.g. a temperature of the magnet or a temperature of the semiconductor substrate; and a correction value D1 can be determined as a predefined function of the measured temperature; and the first angle $\psi$ can be calculated based on dBx/dx and based on the value D1, e.g. as a function of the ratio of dBx/dx and D1, e.g. as an arcsine function of said ratio; and the second angle $\phi$ can be calculated based on dBy/dx and based on the value D1, e.g. as a function of the ratio of dBy/dx and D1, e.g. as an arcsine function of said ratio.

**FIG. 13** shows another semiconductor substrate 1303 with a sensor arrangement which can be seen as another variant of FIG. 11, or as a variant of FIG. 12.

The sensor arrangement of FIG. 13 comprises two 2D magnetic pixels spaced apart along the X-direction by a distance dx, and a 3D magnetic pixel between them, e.g. at the middle between them. The 2D magnetic pixel are each configured for measuring a Bx and a By component. The 3D sensor is configured for measuring three orthogonal magnetic field components Bxc, Byc, Bzc.

The magnetic field components measured by the 3D sensor can be used to determine a norm of the magnetic field at the point C, and this norm can be used for correcting the first gradient dBx/dx and the second gradient dBy/dx. A correction value D2 can be calculated e.g. as a sum of squares of two or three of these magnetic field components, e.g. as D2=sqr(Bxc)+sqr(Byc)+sqr(Bzc).

The first angle $\psi$ can be determined as a function of dBx/dx, with or without the correction value D2, for example as a function of dBx/dx and $\sqrt{D2}$, e.g. as a function of a ratio of the dBx/dx and $\sqrt{D2}$, e.g. as an arcsine function of said ratio.

The second angle $\phi$ can be determined as a function of dBy/dx, with or without the correction value D2, for example as a function of dBy/dx and $\sqrt{D2}$, e.g. as a function of a ratio of the dBy/dx and $\sqrt{D2}$, e.g. as an arcsine function of said ratio.

In a variant, D2 is calculated as sqr(Bxc)+sqr(Bzc), and the vertical Hall elements V11 and V12 may be omitted. In a further variant, the 3D magnetic pixel Sc has an IMC and two horizontal Hall elements for measuring Bxc and Bzc.

In a variant, the sensor Sc has an IMC and four horizontal Hall elements.

In a variant, the sensors S1 and S2 each have an IMC and two or four horizontal Hall elements, and the sensor Sc has an IMC with two or four horizontal Hall elements.

In a variant of any of FIG. 7A to FIG. 13, another correction factor D3 is determined, based on a norm of one or more first order gradients selected from dBx/dx, dBy/dx and dBz/dx. Depending on which gradient is used, the sensors 51, 52 may be 2D sensors or 3D sensors, and no magnetic sensor is required at point C. More specifically, in an example, D3 is calculated as sqr(dBx/dx)+sqr(dBy/dx)+sqr(dBz/dx), or as sqr(dBy/dx)+sqr(dBz/dx), or as sqr(dBx/dx)+sqr(dBz/dx), and the pixels S1 and S2 are 3D magnetic pixels. In another example, D3 is calculated as sqr(dBx/dx)+sqr(dBy/dx), and the pixels S1 and S2 can be 2D pixels (e.g. as in FIG. 12) or 3D pixels. In all of these cases, the first angle $\psi$ can be determined as a function of dBx/dx and the correction value D3, for example as a function of dBx/dx and $\sqrt{D3}$, e.g. as a function of a ratio of the dBx/dx and $\sqrt{D3}$; and the second angle $\phi$ can be determined as a function of dBy/dx and the correction value D3, for example as a function of dBy/dx and $\sqrt{D3}$, e.g. as a function of a ratio of the dBy/dx and $\sqrt{D3}$.

In a variant of any of FIG. 7A to FIG. 13, a magnetic sensor is also present in point C, and another correction factor D4 is determined, based on a norm of one or more second order gradients selected from d2Bx/dx2, d2By/dx2 and d2Bz/dx2. Depending on which second order gradient is used, the sensors 51, 52, Sc may be 2D sensors or 3D sensors. More specifically, in an example, D4 is calculated as sqr(d2Bx/dx2)+sqr(d2By/dx2)+sqr(d2Bz/dx2), or as sqr(d2By/dx2)+sqr(d2Bz/dx2), or as sqr(d2Bx/dx2)+sqr(d2Bz/dx2), and the pixels 51, S2 and Sc are 3D magnetic pixels. In another example, D3 is calculated as sqr(d2Bx/dx2)+sqr(d2By/dx2), and the pixels 51, 52, Sc can be 2D pixels or 3D pixels. In all of these cases, d2Bx/dx2 can be calculated as (Bx2-Bxc)-(Bxc-Bx1), and d2By/dy2 can be calculated as (By2-Byc)-(Byc-By1), and d2Bz/dx2 can be calculated as (Bz2-Bzc)-(Bzc-Bz1), and the first angle $\psi$ can be determined as a function of dBx/dx and the correction value D4, for example as a function of dBx/dx and $\sqrt{D4}$, e.g. as a function of a ratio of the dBx/dx and $\sqrt{D4}$; and the second angle $\phi$ can be determined as a function of dBy/dx and the correction value D4, for example as a function of dBy/dx and $\sqrt{D4}$, e.g. as a function of a ratio of the dBy/dx and $\sqrt{D4}$.

Referring back to **FIG. 8A** and **FIG. 8B,** the inventors also came to the idea of measuring the magnetic field at two other locations, referred to herein as S3 and S4, located on a Y-axis perpendicular to the X-axis, and passing through the point C in the middle between S1 and S2. The sensors S3 and S4 are spaced apart by a distance dy which may be smaller than, equal to, or larger than the distance dx between S1 and S2. As far as the inventors are aware, FIG. 14A and FIG. 14B are not known in the art, but are based on the imagination of the inventors.

**FIG. 14A** shows a variant of FIG. 8A, and the bottom picture gives a qualitative impression of magnetic field vectors at five different locations: C, 51, S2, S3, S4, when the magnet 1401 is in its neutral position ($\psi$=0°, $\phi$=0°).

**FIG. 14B** shows a variant of FIG. 8B, and the bottom picture gives a qualitative impression of the magnetic field vectors at these five locations when the point P of the magnet 1401 is tilted by an angle $\phi$=30° in the YZ-plane, with respect to the Z-axis. As can be seen, the components Bx at S3 and S4 are dependent on $\phi$. The relation between $\Delta$By34 and $\phi$ is similar to that shown in FIG. 9B.

**FIG. 15** shows an enlarged 3D perspective view of FIG. 14A.

The embodiments of **FIG. 16** to **FIG. 21** and the variants thereof, are based on the idea to determine the first angle $\psi$ in the same way as explained above (see e.g. FIG. 7A to FIG. 14), namely based on $\Delta$Bx12 alone, or based on $\Delta$Bx12 and $\Delta$Bz12, or based on $\Delta$Bx12 and a correction factor, e.g. D1 (related to temperature), D2 (related to a norm of field components at point C), D3 (related to a norm of first order gradients at point C), D4 (related to a norm of second order gradients at point C).

**FIG. 16** is a schematic representation of a sensor arrangement as can be used in embodiments of the present invention, e.g. in the sensor device of FIG. 1, and shows a set of formulas for determining the orientation of the magnet by means of a first angle $\psi$ which is determined at least based on $\Delta$Bx12 (or dBx/dx), and by means of a second angle $\phi$ which is determined at least based on $\Delta$Bx34 (or dBx/dy).

The sensor arrangement 1603 of FIG. 16 comprises two 2D magnetic pixels 51, 52 located on the X-axis, each capable of measuring Bx and Bz, and two 1D-magnetic pixels S3, S4 located on the Y-axis, and capable of measuring Bx.

The same remarks as described in FIG. 10A to FIG. 10D, e.g. regarding the location and orientation of the sensors relative to the semiconductor substrate, and the size and shape of the substrate are also applicable here, mutatis mutandis.

In the example of FIG. 16, dx is equal to dy, but that is not absolutely required, and the invention will also work if dx is smaller than dy, or larger than dy.

**FIG. 17** shows a sensor arrangement 1703 which is a variant of FIG. 16, wherein the first and second sensor 51, 52 each comprise a horizontal Hall element for measuring a Bz component, and at least one vertical Hall element arranged for measuring a Bx component.

**FIG. 18** shows a sensor arrangement 1803 which is another variant of FIG. 16, comprising four 2D magnetic pixels, each capable of measuring a Bx component and a By component.

The first angle $\psi$ can be determined as a function of $\Delta$Bx12, or as a function of $\Delta$Bx12 and $\Delta$Bz12, e.g. as a function of a ratio of $\Delta$Bx12 and $\Delta$Bz12, or as a function of $\Delta$Bx12 and $\Delta$Bz34, e.g. as a function of a ratio of $\Delta$Bx12 and $\Delta$Bz34; and the second angle $\phi$ can be determined as a function of $\Delta$Bx34 and $\Delta$Bz12, e.g. as a function of a ratio of $\Delta$Bx34 and $\Delta$Bz12, or as a function of $\Delta$Bx34 and $\Delta$Bz34, e.g. as a function of a ratio of $\Delta$Bx34 and $\Delta$Bz34.

**FIG. 19** shows a sensor arrangement 1903 which is another variant of FIG. 16, as can be used in embodiments of the present invention. This sensor arrangement comprises four 1D magnetic pixels and optionally a temperature sensor.

If the temperature sensor is not present, this sensor arrangement can be used to determine the first angle $\psi$ based on dBx/dx, and to determine the second angle $\phi$ based on dBx/dy, without compensation.

If the temperature sensor is present, a temperature can be measured, e.g. a temperature of the magnet or a temperature of the semiconductor substrate; and a correction value D1 can be determined as a predefined function of the measured temperature; and the first angle $\psi$ can be calculated based on dBx/dx and based on the value D1, e.g. as a function of the ratio of dBx/dx and D1, e.g. as an arcsine function of said ratio; and the second angle $\phi$ can be calculated based on dBx/dy and based on the value D1, e.g. as a function of the ratio of dBx/dy and D1, e.g. as an arcsine function of said ratio.

**FIG. 20** shows a sensor arrangement 2003 which is another variant of FIG. 16, as can be used in embodiments of the present invention, comprising four 1D magnetic pixels and a 3D magnetic pixel between them. The sensors S1 to S4 are capable of measuring a Bx component. The sensor Sc is capable of measuring Bxc, Byc, Bzc at the point C. The sensor Sc may comprise a horizontal Hall element H3 and four vertical Hall elements V9 to V12 (as shown), or may comprise a horizontal Hall element and only two vertical Hall elements (e.g. V9 and V11).

The magnetic field components measured by the 3D sensor can be used to determine a norm of the magnetic field at the point C, and this norm can be used for correcting the first gradient dBx/dx and the second gradient dBy/dx. A correction value D2 can be calculated e.g. as a sum of squares of two or three of these magnetic field components, e.g. as D2=sqr(Bxc)+sqr(Byc)+sqr(Bzc).

The first angle $\psi$ can be determined as a function of dBx/dx, with or without the correction value D2, for example as a function of dBx/dx and $\sqrt{D2}$, e.g. as a function of a ratio of the dBx/dx and $\sqrt{D2}$, e.g. as an arcsine function of said ratio.

The second angle $\phi$ can be determined as a function of dBx/dy, with or without the correction value D2, for example as a function of dBx/dy and $\sqrt{D2}$, e.g. as a function of a ratio of the dBx/dy and $\sqrt{D2}$, e.g. as an arcsine function of said ratio.

In a variant, D2 is calculated as a sum of two of said three components measured at point C, e.g. as sqr(Bxc)+sqr(Bzc), in which case V11 and V12 can be omitted; or as sqr(Bxc)+sqr(Byc), in which case H3 can be omitted; or as sqr(Byc)+sqr(Bzc) in which case V9 and 10 can be omitted.

In a variant, the 3D magnetic pixel Sc has an IMC and two horizontal Hall elements for measuring Bxc and Bzc, or an IMC and two horizontal Hall elements for measuring Byc and Bzc, or an IMC and four horizontal Hall elements.

In a variant, the sensors S1 and S2 each have an IMC and two or four horizontal Hall elements, and the sensor Sc has an IMC with two or four horizontal Hall elements.

**FIG. 21** shows a sensor arrangement 2103 which is another variant of FIG. 16, as can be used in embodiments of the present invention, comprising five 2D magnetic pixels. FIG. 19 can also be seen as a further variant of FIG. 18, further comprising a 2D magnetic pixel at point C, capable of measuring Bxc and Byc.

In this embodiment, a correction factor D4 is determined based on a norm of one or more second order gradients selected from d2Bx/dx2, d2Bx/dy2, d2Bz/dx2 and d2Bz/dy2, wherein d2Bx/dx2= (Bx2-2*Bxc+Bx1), d2Bz/dx2=(Bz2-2*Bzc+Bz1), d2Bx/dy2=(Bx4-2*Bxc+Bx3), d2Bz/dy2=(Bz4-2*Bzc+Bz3).

In an example, D4 is calculated as sqr(d2Bx/dx2)+sqr(d2Bx/dy2)+ sqr(d2Bz/dx2) +sqr(d2Bz/dy2), and the first angle ψ can be determined as a function of dBx/dx and the correction value D4, for example as a function of dBx/dx and √D4, e.g. as a function of a ratio of the dBx/dx and √D4; and the second angle φ can be determined as a function of dBx/dy and the correction value D4, for example as a function of dBx/dy and √D4, e.g. as a function of a ratio of the dBx/dy and √D4.

In a variant, D4 is calculated as a sum of squares of only two or only three of these terms.

Referring back to **FIG. 8A** and **FIG. 8B,** the inventors also came to the idea of measuring the magnetic field at two other locations, referred to herein as S5 and S6, located on an axis YY perpendicular to the X-axis, but offset by a distance dxx>0 from the point C in the middle between S1 and S2. The offset dxx may be smaller than, equal to, or larger than (dx/2). The sensors S5 and S6 are spaced apart by a distance dy which may be smaller than, equal to, or larger than the distance dx between S1 and S2. As far as the inventors are aware, FIG. 224A and FIG. 22B are not known in the art, but are based on the imagination of the inventors.

**FIG. 22A** shows a variant of FIG. 8A, and the bottom picture gives a qualitative impression of magnetic field vectors at five different locations: C, 51, S2, S5, S6, when the magnet 2201 is in its neutral position (ψ=0*, φ=0°).

**FIG. 22B** shows a variant of FIG. 8B, and the bottom picture gives a qualitative impression of the magnetic field vectors at these five locations when the point P of the magnet 2201 is tilted by an angle φ=30° in the YZ-plane, with respect to the Z-axis. As can be seen, the components By and Bz at S5 and S6 seem to be dependent on φ, but it is impossible for a normal human being to predict how the relation between ΔBz56 and φ would look like.

**FIG. 23A** shows an enlarged 3D perspective view of FIG. 22A, without showing the magnetic field lines. The semiconductor substrate 2303 comprises four magnetic sensors located at 51, S2, S5, S6, and optionally a fifth magnetic sensor in point C.

Computer simulations were performed for a cylindrical magnet 2301 having a diameter of 4.0 mm, and a height of 4.0 mm, situated at a distance "g" of 3.0 mm between the substrate and the magnet, for dx=2.2 mm between the two sensor locations 51, 52 to determine how the magnetic field difference ΔBz56=(Bz5-Bz6), also referred to as dBz/dy would vary as a function of φ.

The result is shown in **FIG. 23C.**

In some embodiments of the present invention, the gradient ΔBz56 is corrected using the gradient ΔBz12=(Bz1-Bz2) shown in **FIG. 23B.**

By storing these relationships in the sensor device, and by measuring the value of Bz5 and Bz6, the angle φ can be determined. The relationship can be stored in any suitable manner, for example by means of a mathematical formula, or a lookup table in a non-volatile memory. Such a solution (in which φ is determined based solely on Bz5, Bz6) works well in an environment where the temperature is relatively constant. Thus, for certain applications, such a solution is sufficiently accurate.

In applications where a higher accuracy is required, e.g. in industrial or robotic or automotive applications, some kind of correction may be needed for φ. Again, several solutions will be described, e.g. using the gradient ΔBz12=(Bz1-Bz2) obtainable from S1 and S2, or using a correction value D1 as a function of temperature, or using a correction value D2 indicative of the norm of the magnetic field measured at location C, etc.

In the embodiments shown in FIG. 24A to FIG. 27, the first angle ψ can be determined at least based on ΔBx12=(Bx1-Bx2), optionally corrected using ΔBz12=(Bz1-Bz2), or using a correction value D1 as a function of temperature, or using a correction value D2 indicative of the norm of the magnetic field measured at point C; and the second angle φ can be determined at least based on ΔBz56=(Bz5-Bz6), optionally corrected using ΔBz12, or said correction value D1, or said correction value D2.

FIG. 24A is a schematic representation of a sensor arrangement as can be used in embodiments of the present invention, e.g. in the sensor device of FIG. 1, and shows a set of formulas for determining the orientation of the magnet by means of a first angle ψ which is determined at least based on ΔBx12, and by means of a second angle φ which is determined at least based on ΔBz56.

The sensor arrangement 2403 of FIG. 24A comprises two magnetic pixels 51, 52 located on the X-axis, each capable of measuring at least Bx and preferably also Bz, and two 1D-magnetic pixels S5, S6 located on an axis YY perpendicular to the X-axis, but offset from the point C located in the middle between S1 and S2.

In the example shown in FIG. 24A, the value of dx is equal to dy; and the value of dxx is equal to (dx/2), but that is not required for the invention to work, and the value of dy can be chosen different from the value dx, and the value of dxx can be chosen different from the value (dx/2) or (dy/2), as also illustrated in FIG. 24B to FIG. 24D.

The same remarks as described in FIG. 10A to FIG. 10D, e.g. regarding the location and orientation of the sensors relative to the semiconductor substrate, and the size and shape of the substrate are also applicable here, mutatis mutandis.

**FIG. 24B, FIG. 24C and FIG. 24D** show several variants of FIG. 24A, to illustrate that the two IMC disks do not necessarily need to be located near the corners of the semiconductor substrate, and to demonstrate that the orientation of the Hall plates may be rotated relative to the semiconductor substrate.

In a variant of FIG. 24A to FIG. 24D each of the sensors 51, 52 comprises a horizontal Hall element for measuring Bz, and one or two vertical Hall elements arranged for measuring Bx (e.g. as illustrated in FIG. 11 or FIG. 17).

It is noted that FIG. 24A is not drawn to scale, and in practice all horizontal Hall elements H1 to H6 may have the same size.

**FIG. 25** shows a sensor arrangement 2503 which is a variant of FIG. 24A, further comprising two horizontal Hall elements H7 and H8 located on a virtual line YYY perpendicular to the X-axis, and spaced from the point C by a distance dxxx larger than zero. The distance dxxx may be smaller than, equal to, or larger than (dx/2). Preferably the value of dxxx and dxx are equal to (dx/2) and preferably the value of dy is equal to dx, in which case the four horizontal Hall elements H5, H6, H7, H8 are located on a virtual square with the point C in the center of the square, and the sensors S1 and S2 are located on the sides of the square, as shown.

The signal $\Delta$Bz12=(Bz1-Bz2) is mainly dependent on the first angle $\psi$.

The signal $\Delta$Bz56=(Bz5-Bz6) is dependent both on $\psi$ and on $\phi$, and the signal $\Delta$Bz78=(Bz7-Bz8) is dependent both on $\psi$ and on $\phi$, but the sum of the signals ($\Delta$Bz56+$\Delta$Bz78)=(Bz5-Bz6+Bz7-Bz8) is less dependent on $\psi$. In an embodiment, this sum may be used as a correction value.

It is also possible to use a weighted sum of the signals $\Delta$Bz56 and $\Delta$Bz78, e.g. in accordance with the formula: $\Delta$BzS-8=(w1*$\Delta$Bz56)+(w2*$\Delta$Bz78), where w1,w2 are weight factors. These weight factors may be predefined values, or may be predefined functions of the value of $\psi$.

**FIG. 26** shows a sensor arrangement 2603 which is another variant of FIG. 24A, as can be used in embodiments of the present invention. This sensor arrangement is extremely simple, in that it comprises only two vertical Hall elements V1, V2 located on the X-axis, and two horizontal Hall elements H5, H6 located on the YY-axis. In the example shown, the sensor V2 is also located on the YY-axis, but as explained above, that is not absolutely required.

Optionally the sensor arrangement 2603 further comprises a temperature sensor. In this case a correction value D1 can be calculated as a function of the measured temperature; and the first angle $\psi$ can be determined based on $\Delta$Bx12 and the correction value D1, e.g. as a function of the ratio of $\Delta$Bx12 and D1, e.g. as an arcsin function of that ratio; and the second angle $\phi$ can be determined based on $\Delta$Bz56 and the correction value D1, or based on $\Delta$Bz56 and D1 and $\psi$.

In a variant (not shown) of FIG. 26, the sensor arrangement 2603 may further comprise a 3D magnetic pixel located at the point C capable of measuring (Bxc, Byc, Bzc), or a 2D magnetic pixel located at point C capable of measuring (Bxc, Bzc). A correction value D2 can be calculated as a sum of squares of these three values Bxc, Byc, Bzc or as a sum of squares of the two values Bxc, Bzc; and the first angle $\psi$ can be calculated as a function of $\Delta$Bx12 and D2, e.g. as a function of (ABx12/√D2); and the second angle $\phi$ can be calculated as a function of $\Delta$Bz56 and D2, e.g. as a function of (ABz56/√D2).

**FIG. 27** shows a sensor arrangement 2703 which is another variant of FIG. 24A, but can also be seen as a variant of FIG. 25 where S1 and S2 are replaced by 1D magnetic sensors, or as a variant of FIG. 26 where two horizontal Hall elements H7, H8 are added. This sensor arrangement optionally comprises a temperature sensor.

If the sensor arrangement 2703 comprises a temperature sensor, a correction value D1 can be calculated as a function of the measured temperature; and the first angle $\psi$ can be determined based on $\Delta$Bx12 and the correction value D1, e.g. as a function of the ratio of $\Delta$Bx12 and D1, e.g. as an arcsin function of that ratio; and the second angle $\phi$ can be determined based on $\Delta$Bz56 and the correction value D1, or based on $\Delta$Bz56 and $\Delta$Bz78 and D1, or based on $\Delta$Bz56 and $\Delta$Bz78 and D1 and $\psi$, e.g. based on D1 and on a sum or average or weighted average of $\Delta$Bz56 and $\Delta$Bz78.

In all embodiments shown above, a first angle $\psi$ is determined individually, and a second angle $\phi$ can be determined independent from the first angle or dependent on the first angle. In certain embodiments, it is possible to consider the so calculated values to be a first estimate of the orientation, and to perform a correction as a post-processing step, e.g. using a two-dimensional look-up table, optionally with interpolation. The values of this look-up table may be determined during a calibration procedure, and may be stored in a non-volatile memory of the sensor device.

In the embodiments shown above, only horizontal Hall elements and vertical Hall elements are shown, but it is of course also possible to use other magnetic sensor structures, if they are capable of measuring the same magnetic field components, e.g. magnetoresistive (MR) sensors.

The simulations were performed for a cylindrical two-magnet with a diameter D of 4.0 mm and a height H of 4.0 mm, located at a distance "g" of 3.0 mm from the semiconductor substrate that contains at least two sensor locations S1 and S2 spaced apart by a distance dx of 1.1 mm or 1.6 mm or 2.2 mm, but of course the present invention is not limited hereto, and also works for two-pole magnets with other dimensions and/or situated at another distance "g" from the semiconductor substrate, and for semiconductor substrates where the distance dx between S1 and S2 is smaller than 1.1 mm or larger than 2.2 mm (e.g. a value in the range from 1.0 mm to 3.0 mm).

In sensor systems according to the present invention, the magnet is pivotable about a reference point "Pref" having a predefined location with respect to the semiconductor substrate. This point is preferably located on the Z-axis perpendicular to the substrate and passing through the point "C". As already mentioned above, the reference point "Pref" may be located on the positive Z-axis, meaning that the magnet and the reference point "Pref" are located on the same side of the substrate, or may be located in the semiconductor substrate (as illustrated in FIG. 1), or may be located on the negative Z-axis, i.e. on the opposite side of the substrate as the magnet. But the present invention is not limited thereto, and the present invention will also work if the (real or imaginary) reference point "Pref" about which the axis of the magnet is pivotable, is situated inside the space defined by the magnet, or above the space defined by the magnet. It was found that the same formulas as described above for calculating $\psi$ and $\phi$ may also be used in these cases. Optionally the sensor device may be further adapted for applying a post-processing on these angles, in manners known per se in the art, e.g. by applying a first piecewise-linear correction for the angle $\psi$, using a first set of predefined coefficients, and by applying a second piecewise-linear correction for the angle $\phi$, using a second set of predefined coefficients. These coefficients may be determined during a calibration step, and may be stored in a non-volatile memory of the sensor device. In another embodiment, the post-processing step may be based on a two-dimensional look-up table, with two-dimensional interpolation.

**FIG. 28** shows an electrical block-diagram of a sensor device 2802 as can be used in the position sensor system 100 of FIG. 1.

The sensor device 2802 comprises a semiconductor substrate with a plurality of magnetic sensor elements M1 to M4 (e.g. horizontal Hall elements, vertical Hall elements, magneto-resistive (MR) elements, etc.), providing signals m1, m2, m3, m4, etc., and a processing unit 2830 (e.g. comprising analog components and/or digital components), and a non-volatile memory 2531 (e.g. eeprom or flash).

The plurality of magnetic sensor elements M1, M2, etc. may be part of a sensor arrangement described above, e.g. as illustrated in FIG. 10A to FIG. 13 or variants thereof, or as illustrated in FIG. 16 to FIG. 21 or variants thereof, or as illustrated in FIG. 24A to FIG. 27 or variants thereof.

The sensor device 2802 may further comprise a temperature sensor, which may be incorporated in the semiconductor substrate that contains the magnetic sensor elements.

The sensor device 2802 further comprises a biasing and readout circuit (not shown). Biasing and readout of Hall sensors, or of circuits comprising MR elements is well known in the art, and hence need not be explained in further detail here.

The sensor device 2802 also comprises a processing circuit 2830, which may be implemented on the same semiconductor substrate as the one containing the magnetic sensors, or on a second semiconductor substrate communicatively connected to the first semiconductor substrate. The processing circuit is configured for determining a first angle $\psi$ or $\alpha$ and a second angle $\phi$ or $\beta$, for example by using the mathematical formulas described above and/or illustrated in the Figures, and/or by using one or more look-up table(s) optionally with interpolation. Optionally a post-correction step is also applied.

The addition or subtraction of signals for determining magnetic field components (e.g. h2-h1 in FIG. 3A) and/or for determining magnetic field gradients (e.g. Bx2-Bx1 in FIG. 3A) may be performed in the analog domain before or after amplification, or in the digital domain.

The processing unit 2830 may comprise a digital processor, which may optionally comprise or be connected to a non-volatile memory 2531 (e.g. NVRAM or EEPROM or FLASH). This memory may comprise one or more constants, lookup-tables, coefficients of a polynomial, etc. The digital processor 2530 may for example be an 8-bit processor, or a 16-bit processor.

While not explicitly shown, the sensor device 2802 may further comprise one or more components or sub-circuits selected from the group consisting of: an amplifier, a differential amplifier, an analog-to-digital convertor (ADC), a multiplexer, etc. The ADC may have a resolution of at least 8 bits, or at least 10 bits, or at least 12 bits, or at least 14 bits, or at least 16 bits.

REFERENCES:

| | |
|---|---|
| Pref | reference point |
| C | point in the middle between sensor S1 and S2 |
| P | point in the centre of the magnet |
| $\psi$ | first angle (between Z-axis and projection of vector CP in plane XZ) |
| $\alpha$ | (alternative) first angle (between X-axis and projection of vector CP in plane XZ) |
| $\phi$ | second angle (between Z-axis and projection of vector CP in plane YZ) |
| $\beta$ | (alternative) second angle (between Y-axis and projection of vector CP in plane YZ) |
| 51, 52, | first, second sensor |
| H1, H2, | first, second horizontal Hall element |
| h1, h2, | signal obtained from H1, H2 |
| V1, V2, | first, second vertical Hall element |
| v1, v2, | signal obtained from V1, V2 |
| g | distance between substrate and magnet (sometimes also referred to as "airgap") |
| Bx | magnetic field component oriented in the X-direction |
| By | magnetic field component oriented in the Y-direction |
| Bz | magnetic field component oriented in the Z-direction |
| dBy/dx | magnetic field gradient of By component along the X-axis |
| S1(Bx1,By1) | first magnetic sensor (pixel) capable of measuring Bx and By component |

REFERENCES modulo 100:

-00    position sensor system, e.g. joystick assembly
-01    magnet
-02    sensor device
-03    semiconductor substrate with sensor arrangement
-30    processing circuit
-31    non-volatile memory

**Claims**

1. A sensor device (102) for determining an orientation $(\alpha,\beta,\phi,\psi)$ of a two-pole magnet (101);

   the sensor device comprising a semiconductor substrate (903; 1003; 1103; 1203; 1303) comprising or connected to at least a first and a second magnetic sensor (51, 52) spaced apart in a first direction (X) by a predefined distance (dx);
   wherein each of the first and second magnetic sensor (51, 52) is configured for measuring a first magnetic field component (Bxl, Bx2) oriented in said first direction (X), and a second magnetic field component (By1, By2) oriented in a second direction (Y) parallel to the semiconductor substrate and perpendicular to the first direction (X);
   wherein the magnet (101) is movable relative to the sensor device such that a centre (P) of the magnet is pivotable about a reference point (Pref) having a predefined position relative to the semiconductor substrate;
   wherein the sensor device further comprises a processing circuit (2830) configured:

   i) for determining a first magnetic field gradient (dBx/dx) of the first magnetic field components (Bxl, Bx2) along said first direction (X); and
   ii) for determining a second magnetic field gradient (dBy/dx) of the second magnetic field components (By1, By2) along said first direction (X); and
   iii) for determining a first angle $(\alpha,\psi)$ based on the first magnetic field gradient (dBx/dx); and
   iv) for determining a second angle $(\beta,\phi)$ based on the second magnetic field gradient (dBy/dx).

2. A sensor device according to claim 1,

   wherein the magnet (101) is magnetized in a direction substantially parallel to the semiconductor substrate when a virtual line passing through the centre (P) of the magnet and through the reference point (Pref) is oriented substantially perpendicular to the semiconductor substrate;
   or wherein an orthogonal projection of the centre (P) of the magnet upon the semiconductor substrate, substantially coincides with a point (C) located in the middle between the first sensor (51) and the second sensor (S2);
   or wherein the magnet is magnetized in a direction substantially perpendicular to a virtual line passing through the centre (P) of the magnet and through the reference point (Pref).

3. A sensor device according to any of the previous claims,

   wherein each of the first and second magnetic sensor (51, 52) is further configured for measuring a third magnetic field component (Bzl, Bz2) oriented in a third direction (Z) perpendicular to the substrate;
   and wherein the processing circuit is further configured

   v) for determining a third magnetic field gradient (dBz/dx) of the third magnetic field component (Bzl, Bz2) along said first direction (X);
   iii) for determining the first angle $(\alpha,\psi)$ based on the first and the third magnetic field gradient (dBx/dx, dBz/dx); and
   iv) for determining the second angle $(\beta,\phi)$ based on the second and the third magnetic field gradient (dBy/dx, dBz/dx).

4. A sensor device according to claim 1 or 2,

   further comprising a temperature sensor for measuring a temperature;
   and wherein the processing circuit is configured:
   for determining a correction factor D1 as a predefined function of the measured temperature; and

   iii) for determining the first angle $(\alpha,\psi)$ based on the first magnetic field gradient (dBx/dx) and the correction factor D1;
   iv) for determining the second angle $(\beta,\phi)$ based on the second magnetic field gradient (dBy/dx) and the correction factor D1.

5. A sensor device according to claim 1 or 2,

   wherein the semiconductor substrate further comprises a third magnetic sensor (S3) located in the middle (C) between the first and the second magnetic sensor (51, S2), configured for determining two or more of the following: a magnetic field component (Bxc) oriented in the first direction (X), a magnetic field component (Byc) oriented in the second direction (Y), a magnetic field component (Bzc) oriented in the third direction (Z);

and wherein the processing circuit is configured: for determining a correction factor D2 as a sum of squares of two or more of the magnetic field components (Bxc, Byc, Bzc) measured by the third magnetic sensor (S3); and

    iii) for determining the first angle $(\alpha,\psi)$ based on the first magnetic field gradient (dBx/dx) and the correction factor D2;
    iv) for determining the second angle $(\beta,\phi)$ based on the second magnetic field gradient (dBy/dx) and the correction factor D2.

6.    A sensor device according to claim 1 or 2,
wherein the processing circuit is configured:
for determining a correction factor D3a as a sum of squares of the first and the second magnetic field gradient (dBx/dx, dBy/dx); and

    iii) for determining the first angle $(\alpha,\psi)$ based on the first magnetic field gradient (dBx/dx) and the correction factor D3a;
    iv) for determining the second angle $(\beta,\phi)$ based on the second magnetic field gradient (dBy/dx) and the correction factor D3a.

7.    A sensor device according to claim 1 or 2,

    wherein each of the first and second magnetic sensor (51, 52) is further configured for measuring a third magnetic field component (Bzl, Bz2) oriented in a third direction (Z) perpendicular to the substrate; and
    wherein the processing circuit is configured:

        for determining a third magnetic field gradient (dBz/dx) of the third magnetic field component (Bzl, Bz2) along said first direction (X); and
        for determining a correction factor D3b as a sum of squares of two or three of said first, second and third magnetic field gradient (dBx/dx, dBy/dx, dBz/dx); and

        iii) for determining the first angle $(\alpha,\psi)$ based on the first magnetic field gradient (dBx/dx) and the correction factor D3b;
        iv) for determining the second angle $(\beta,\phi)$ based on the second magnetic field gradient (dBy/dx) and the correction factor D3b.

8.    A sensor device according to claim 1 or 2,

    wherein the semiconductor substrate further comprises a third magnetic sensor (S3) located in the middle (C) between the first and the second magnetic sensor (51, S2), and configured for determining a magnetic field component (Bxc) oriented in the first direction (X), and a magnetic field component (Byc) oriented in the second direction (Y);
    and wherein the processing circuit is configured:

        for determining a second order gradient (d2Bx/dx2) of the first magnetic field component (Bx) along the first direction (X), and a second order gradient (d2By/dx2) of the second magnetic field component (By) along the first direction (X); and
        for determining a correction factor D4a as a sum of squares of these second order gradients; and

        iii) for determining the first angle $(\alpha,\psi)$ based on the first magnetic field gradient (dBx/dx) and the correction factor D4a;
        iv) for determining the second angle $(\beta,\phi)$ based on the second magnetic field gradient (dBy/dx) and the correction factor D4a.

9.    A sensor device according to claim 1 or 2,

    wherein each of the first and second magnetic sensor (51, 52) is further configured for measuring a third magnetic field component (Bzl, Bz2) oriented in a third direction (Z) perpendicular to the substrate; and
    wherein the semiconductor substrate further comprises a third magnetic sensor (S3) located in the middle (C) between the first and the second magnetic sensor (51, S2), configured for determining a magnetic field component Bxc oriented in the first direction (X), a magnetic field component Byc oriented in the second direction (Y), a magnetic field component Bzc oriented in the third direction (Z);
    and wherein the processing circuit is configured:

        for determining one or more of the following: a second order gradient (d2Bx/dx2) of the first magnetic field component (Bx) along the first direction (X), a second order gradient (d2By/dx2) of the second magnetic field component (By) along the first direction (X), a second order gradient (d2Bz/dx2) of the third magnetic field component (Bz) along the first direction (X); and
for determining a correction factor D4b as a sum of squares of two or three of said second order gradients; and

iii) for determining the first angle ($\alpha,\psi$) based on the first magnetic field gradient (dBx/dx) and the correction factor D4b;
iv) for determining the second angle ($\beta,\phi$) based on the second magnetic field gradient (dBy/dx) and the correction factor D4b.

10. A sensor system (100) comprising:

- a magnetic sensor device (102) according to any of the previous claims;
- a two-pole magnet (101), magnetized or oriented as specified in claim 2.

11. A sensor device (102) for determining an orientation ($\alpha,\beta,\phi,\psi$) of a two-pole magnet (101);

the sensor device comprising a semiconductor substrate comprising or is connected to at least four magnetic sensors (51, S2, S3, S4) situated on a virtual ellipse, including a first and a second magnetic sensor (51, 52) spaced apart in a first direction (X) by a first predefined distance (dx), and including a third and a fourth magnetic sensor (S3, S4) spaced apart by a second predefined distance (dy) in a second direction (Y) parallel to the semiconductor substrate and perpendicular to the first direction (X);
wherein each magnetic sensor (51, S2, S3, S4) is configured for measuring a first magnetic field component (Bxl, Bx2, Bx3, Bx4) oriented in said first direction (X);
wherein the magnet is movable relative to the sensor device such that a centre (P) of the magnet is pivotable about a reference point (Pref) having a predefined position relative to the semiconductor substrate;
wherein the sensor device further comprises a processing circuit configured:

i) for determining a first magnetic field gradient (dBx/dx) along said first direction (X) based on signals obtained from the first and the second sensor (51, S2); and
ii) for determining a second magnetic field gradient (dBx/dy) along said second direction (Y) based on signals obtained from the third and the fourth sensor (S3, S4); and
iii) for determining a first angle ($\alpha,\psi$) based on the first magnetic field gradient (dBx/dx);

and
iv) for determining a second angle ($\beta,\phi$) based on the second magnetic field gradient (dBx/dy).

12. A sensor device according to claim 11,

wherein the magnet is magnetized in a direction substantially parallel to the semiconductor substrate when a virtual line passing through the centre (P) of the magnet and through the reference point (Pref) is oriented substantially perpendicular to the semiconductor substrate;
or wherein an orthogonal projection of the centre (P) of the magnet upon the semiconductor substrate, substantially coincides with a point (C) located in the middle between the first sensor (51) and the second sensor (S2);
or wherein the magnet is magnetized in a direction substantially perpendicular to a virtual line passing through the centre (P) of the magnet and through the reference point (Pref).

13. A sensor device according to claim 11 or 12,

wherein each of the first and second magnetic sensor (51, 52) is further configured for measuring a third magnetic field component (Bzl, Bz2) oriented in a third direction (Z) perpendicular to the substrate;
and wherein the processing circuit is configured:

v) for determining a third magnetic field gradient (dBz/dx) of the third magnetic field component (Bzl, Bz2) along said first direction (X); and
iii) for determining the first angle ($\alpha,\psi$) based on the first and the third magnetic field gradient (dBx/dx, dBz/dx); and
iv) for determining the second angle ($\beta,\phi$) based on the second and the third magnetic field gradient (dBx/dy, dBz/dx).

14. A sensor device according to claim 11 or 12,

wherein each magnetic sensor (51, S2, S3, S4) is further configured for measuring a third magnetic field component (Bzl, Bz2, Bz3, Bz4) oriented in a third direction (Z) perpendicular to the substrate;
and wherein the processing circuit is configured:

v) for determining a third magnetic field gradient (dBz/dx) of the third magnetic field components (Bzl, Bz2) obtained from the first and second magnetic sensor (51, 52) along said first direction (X); and
vi) for determining a fourth magnetic field gradient (dBz/dy) of the third magnetic field components (Bz3, Bz4) obtained from the third and fourth magnetic sensor (S3, S4) along said second direction (Y); and

iii) for determining the first angle ($\alpha,\psi$) based on the first and the third magnetic field gradient (dBx/dx, dBz/dx); and

iv) for determining the second angle ($\beta,\phi$) based on the second and the fourth magnetic field gradient (dBx/dy, dBz/dy).

15. A sensor device according to claim 11 or 12,

further comprising a temperature sensor for measuring a temperature;

and wherein the processing circuit is configured: for determining a correction factor D1 as a predefined function of the measured temperature; and

iii) for determining the first angle ($\alpha,\psi$) based on the first magnetic field gradient (dBx/dx) and the correction factor D1;

iv) for determining the second angle ($\beta,\phi$) based on the second magnetic field gradient (dBx/dy) and the correction factor D1.

16. A sensor device according to claim 11 or 12,

wherein the semiconductor substrate further comprises a fifth magnetic sensor (Sc) located in the middle (C) between the first and the second magnetic sensor (51, S2), configured for determining two or more of the following: a magnetic field component (Bxc) oriented in the first direction (X), a magnetic field component (Byc) oriented in the second direction (Y), a magnetic field component (Bzc) oriented in the third direction (Z);

and wherein the processing circuit is configured: for determining a correction factor D2 as a sum of squares of two or more of the magnetic field components (Bxc, Byc, Bzc) measured by the fifth magnetic sensor (Sc); and

iii) for determining the first angle ($\alpha,\psi$) based on the first magnetic field gradient (dBx/dx) and the correction factor D2;

iv) for determining the second angle ($\beta,\phi$) based on the second magnetic field gradient (dBx/dy) and the correction factor D2.

17. A sensor device according to claim 11 or 12, wherein the processing circuit is configured: for determining a correction factor D3a as a sum of squares of the first and the second magnetic field gradient (dBx/dx, dBx/dy); and

iii) for determining the first angle ($\alpha,\psi$) based on the first magnetic field gradient (dBx/dx) and the correction factor D3a;

iv) for determining the second angle ($\beta,\phi$) based on the second magnetic field gradient (dBx/dy) and the correction factor D3a.

18. A sensor device according to claim 11 or 12,

wherein at least two of the magnetic sensors (51, S2, S3, S4) are further configured for measuring a third magnetic field component (Bzl, Bz2, Bz3, Bz4) oriented in a third direction (Z) perpendicular to the substrate;

and wherein the processing circuit is configured:

v) for determining a third magnetic field gradient (dBz/dx) of the third magnetic field components (Bzl, Bz2) obtained from the first and second magnetic sensor (51, 52) along said first direction (X); and

vi) for determining a fourth magnetic field gradient (dBz/dy) of the third magnetic field components (Bz3, Bz4) obtained from the third and fourth magnetic sensor (S3, S4) along said second direction (Y); and

wherein the processing circuit is configured: for determining a correction factor D3b as a weighted sum of at least three squares of the first, second, third and fourth magnetic field gradient (dBx/dx, dBx/dy, dBz/dx, dBz/dy); and

iii) for determining the first angle ($\alpha,\psi$) based on the first magnetic field gradient (dBx/dx) and the correction factor D3b;

iv) for determining the second angle ($\beta,\phi$) based on the second magnetic field gradient (dBx/dy) and the correction factor D3b.

19. A sensor device according to claim 11 or 12,

wherein the semiconductor substrate further comprises a fifth magnetic sensor (Sc) located in the middle (C) between the first and the second magnetic sensor (51, S2), and configured for determining a magnetic field component Bxc oriented in the first direction (X);

and wherein the processing circuit is configured:

v) for determining a second order gradient (d2Bx/dx2) of the first magnetic field component (Bx) along the first direction (X); and

vi) for determining a second order gradient (d2Bx/dy2) of the first magnetic field component (Bx) along the second direction (Y); and

for determining a correction factor D4a as a sum of squares of these second order gradients (d2Bx/dx2, d2Bx/dy2); and

iii) for determining the first angle $(\alpha,\psi)$ based on the first magnetic field gradient (dBx/dx) and the correction factor D4a;
iv) for determining the second angle $(\beta,\phi)$ based on the second magnetic field gradient (dBx/dy) and the correction factor D4a.

20. A sensor device according to claim 11 or 12,

wherein at least two of the four magnetic sensors (51, S2, S3, S4) is further configured for measuring a third magnetic field component (Bzl, Bz2, Bz3, Bz4) oriented in a third direction (Z) perpendicular to the substrate; and
wherein the semiconductor substrate further comprises a fifth magnetic sensor (Sc) located in the middle (C) between the first and the second magnetic sensor (51, S2), configured for determining a magnetic field component Bxc oriented in the first direction (X) and a magnetic field component Bzc oriented in the third direction (Z);
and wherein the processing circuit is configured:

for determining two or more of the following: a second order gradient (d2Bx/dx2) of the first magnetic field component (Bx) along the first direction (X), a second order gradient (d2Bx/dy2) of the first magnetic field component (Bx) along the second direction (Y), a second order gradient (d2Bz/dx2) of the third magnetic field component (Bz) along the first direction (X), a second order gradient (d2Bz/dy2) of the third magnetic field component (Bz) along the second direction (Y); and
for determining a correction factor D4b as a weighted sum of two or more squares of these second order magnetic field gradients (d2Bx/dx2, d2Bx/dy2, d2Bz/dx2, d2Bz/dy2); and

iii) for determining the first angle $(\alpha,\psi)$ based on the first magnetic field gradient (dBx/dx) and the correction factor D4b;
iv) for determining the second angle $(\beta,\phi)$ based on the second magnetic field gradient (dBy/dx) and the correction factor D4b.

21. A sensor system (100) comprising:

- a magnetic sensor device (102) according to any of the claims 11 to 20;
- a two-pole magnet (101), magnetized or oriented as specified in claim 12.

22. A sensor device (102) for determining an orientation $(\alpha,\beta,\phi,\psi)$ of a two-pole magnet (101);

the sensor device comprising a semiconductor substrate comprising or connected to a first and a second magnetic sensor (51, 52) spaced apart in a first direction (X) by a predefined distance (dx), each of the first and second sensor (51, 52) capable of measuring a magnetic field component (Bxl, Bx2) oriented in said first direction (X);
the semiconductor substrate further comprising: a third and a fourth magnetic sensor (S5, S6) spaced apart in a second direction (Y) parallel to the semiconductor substrate and perpendicular to the first direction (X), the third and fourth sensor (S5, S6) being located on a virtual line YY which is offset (dxx) from a perpendicular bisector (Y) defined by the first and the second sensor (51, S2), each of the third and fourth sensor (S5, S6) capable of measuring a magnetic field component (Bz5, Bz6) oriented in a third direction, perpendicular to the substrate;
wherein the magnet is movable relative to the sensor device such that a centre (P) of the magnet is pivotable about a reference point (Pref) having a predefined position relative to the semiconductor substrate;
wherein the sensor device further comprises a processing circuit configured:

i) for determining a first magnetic field gradient (dBx/dx) of the magnetic field components (Bxl, Bx2) obtained from the first and second magnetic sensor (51, 52) along the first direction (X); and
ii) for determining a second magnetic field gradient (dBz/dy) of the magnetic field components (Bz5, Bz6) obtained from the third and fourth magnetic sensor (S5, S6) along the second direction (Y); and
iii) for determining a first angle $(\alpha,\psi)$ based on the first magnetic field gradient (dBx/dx); and
iv) for determining a second angle $(\beta,\phi)$ based on the second magnetic field gradient (dBz/dy).

23. A sensor device according to claim 22,

wherein the magnet is magnetized in a direction substantially parallel to the semiconductor substrate when a virtual line passing through the centre (P) of the magnet and through the reference point (Pref) is oriented substantially perpendicular to the semiconductor substrate; or wherein an orthogonal projection of the centre (P) of the magnet upon the semiconductor substrate, substantially coincides with a point (C) located in the middle between the first sensor (51) and the second sensor (S2); or wherein the magnet is magnetized in a direction substantially perpendicular to a virtual line passing through the centre (P) of the magnet and through the reference point (Pref).

24. A sensor device according to claim 22 or 23,

wherein each of the first and second magnetic sensor (51, 52) is further configured for measuring a magnetic field component (Bzl, Bz2) oriented in the third direction (Z) perpendicular to the substrate; and wherein the processing circuit is further configured

v) for determining a third magnetic field gradient (dBz/dx) of the magnetic field components (Bzl, Bz2) oriented in the third direction (Z) along the first direction (X); and iii) for determining the first angle $(\alpha,\psi)$ based on the first and the third magnetic field gradient (dBx/dx, dBz/dx); and iv) for determining the second angle $(\beta,\phi)$ based on the second and the third magnetic field gradient (dBz/dy, dBz/dx).

25. A sensor device according to claim 22 or 23,

further comprising a temperature sensor for measuring a temperature; and wherein the processing circuit is configured: for determining a correction factor D1 as a predefined function of the measured temperature; and

iii) for determining the first angle $(\alpha,\psi)$ based on the first magnetic field gradient (dBx/dx) and the correction factor D1; iv) for determining the second angle $(\beta,\phi)$ based on the second magnetic field gradient (dBz/dy) and the correction factor D1.

26. A sensor device according to claim 22 or 23,

wherein the semiconductor substrate further comprises a fifth magnetic sensor (Sc) located in the middle (C) between the first and the second magnetic sensor (51, S2), configured for determining two or more of the following: a magnetic field component (Bxc) oriented in the first direction (X), a magnetic field component (Byc) oriented in the second direction (Y), a magnetic field component (Bzc) oriented in the third direction (Z); and wherein the processing circuit is configured: for determining a correction factor D2 as a sum of squares of two or more of the magnetic field component (Bxc, Byc, Bzc) measured by the fifth magnetic sensor (Sc); and

iii) for determining the first angle $(\alpha,\psi)$ based on the first magnetic field gradient (dBx/dx) and the correction factor D2; iv) for determining the second angle $(\beta,\phi)$ based on the second magnetic field gradient (dBy/dx) and the correction factor D2.

27. A sensor system (100) comprising:

- a magnetic sensor device (102) according to any of the claims 22 to 26; - said magnet (101), magnetized as specified in claim 23.

28. A sensor system (100) comprising:

- a sensor device (102) comprising: a semiconductor substrate comprising or connected to a plurality of magnetic sensors (51,52; 51,52,53,54; 51,52,55,56) spaced apart from each other; the sensor device further comprising a processing circuit configured for determining at least a first and a second magnetic field gradient, and for determining a first angle $(\alpha,\psi)$ based on the first magnetic field gradient, and for determining a second angle $(\beta,\phi)$ based on the second magnetic field gradient; - a two-pole magnet (101) that is movable relative to the sensor device such that a centre (P) of the magnet is pivotable about a reference point (Pref) having a predefined position relative to the semiconductor substrate; - wherein the magnet (101) is magnetized in a direction parallel to the semiconductor substrate when a virtual line passing through the centre (P) of the magnet and through the reference point (Pref) is oriented perpendicular to the semiconductor substrate, or wherein an orthogonal projection of the centre (P) of the magnet upon the semiconductor substrate substantially coincides with a point (C) located in the middle between the first sensor (51) and the second sensor (52), or wherein the magnet is magnetized in a direction substantially perpendicular to a virtual line passing through the centre (P) of the magnet and through the reference point (Pref).

29. A sensor system according to claim 28,

wherein the plurality of magnetic sensors comprise two sensors (51, 52) spaced apart along a first direction (X), wherein each of the sensors is capable of measuring at least two magnetic field components;

or wherein the plurality of magnetic sensors comprise four sensors (51,52,53,54; 51,52,55,56), including a first and a second sensor (51, 52) spaced apart along a first direction (X), and including a third and a fourth sensor (S3,S4; S5, S6) spaced apart in a second direction (Y), wherein each of the four sensors is capable of measuring at least one magnetic field component.

30. A sensor system according to claim 28 or 29,

wherein the plurality of magnetic sensors comprise only horizontal or vertical Hall elements; or
wherein the plurality of magnetic sensors comprise only horizontal Hall elements; or
wherein the plurality of sensors comprise only vertical Hall elements.

31. A sensor system according to any of the claims 28 to 30,
wherein the sensor device comprises at least one cmos substrate.

**FIG. 1**

$$Bx=B*Cos(Alpha)*Sin(Beta)$$
$$By=B*Cos(Beta)*Sin(Alpha)$$
$$Bz=B*Sin(Beta)*Sin(Alpha)$$

**FIG. 2**

Bx1=(h2-h1)
Bz1=(h2+h1)

Bx2=(h4-h3)
Bz2=(h4+h3)

$\Delta$Bx12=dBx/dx = (Bx2-Bx1)
$\Delta$Bz12=dBz/dx = (Bz2-Bz1)

## FIG. 3A

Bx1=(h2-h1)
Bz1=(h2+h1)

Bx2=(h4-h3)
Bz2=(h4+h3)

$\Delta$Bx12=dBx/dx = (Bx2-Bx1)
$\Delta$Bz12=dBz/dx = (Bz2-Bz1)

## FIG. 3B

Y

Z⊙→X

H2

H1    IMC    H3

H4

Bx=(h3-h1)
By=(h2-h4)
Bz=(h1+h3)
    or (h2+h4)
    or (h1+h2+h3+h4)

# FIG. 4A

Y

Z⊙→X

H2

H1    IMC    H3

H4

Bx=(h3-h1)
By=(h2-h4)
Bz=(h1+h3)
    or (h2+h4)
    or (h1+h2+h3+h4)

# FIG. 4B

Y

Z⊙→X

V2

V1    H1    V3

V4

Bx=v1 or v3 or (v1+v3)
By=v2 or v4 or (v2+v4)
Bz=h1

# FIG. 5

**FIG. 6A**

**FIG. 6B**

**FIG. 7A**

**FIG. 7B**

**FIG. 7C**

φ (or β)

801

P

Z

X ⊙ → Y

S3  C  S4

X

Y

X

S1

C

S2

**FIG. 8A**

φ (or β)

801

P

Z

X ⊙ → Y

S3  C  S4

X

Y

X

S1

C

S2

**FIG. 8B**

FIG. 9A

FIG. 9B

FIG. 9C

1003a

$Bx1=(h1-h3);$  $By1=(h2-h4);$  $Bz1=(h1+h2+h3+h4);$
$Bx2=(h5-h7);$  $By2=(h6-h8);$  $Bz2=(h5+h6+h7+h8);$
$\Delta Bx_{12}=dBx/dx=(Bx1-Bx2);$
$\Delta By_{12}=dBy/dx=(By1-By2);$
$\Delta Bz_{12}=dBz/dx=(Bz1-Bz2);$
----

$\psi=f101(\Delta Bx_{12});$  |  $\varphi=f104(\Delta By_{12})$

e.g. $\psi=f102(\Delta Bx_{12},\Delta Bz_{12});$ | e.g. $\varphi=f105(\Delta By_{12},\Delta Bz_{12})$

e.g. $\psi=f103(\Delta Bx_{12}/\Delta Bz_{12});$ | e.g. $\varphi=f106(\Delta By_{12}/\Delta Bz_{12})$

e.g. $\psi=atan2(\Delta Bx_{12},\Delta Bz_{12});$ | e.g. $\varphi=atan2(\Delta By_{12},\Delta Bz_{12})$

# FIG. 10A

FIG. 10B

FIG. 10C

FIG. 10D

1103

$Bx1=(v1+v2);$  $By1=(v3+v4);$  $Bz1=(h1);$
$Bx2=(v5+v6);$  $By2=(v7+v8);$  $Bz2=(h2);$
$\Delta Bx_{12}=dBx/dx=(Bx1-Bx2);$
$\Delta By_{12}=dBy/dx=(By1-By2);$
$\Delta Bz_{12}=dBz/dx=(Bz1-Bz2);$

----

| $\psi=f111(\Delta Bx_{12});$ | $\varphi=f114(\Delta By_{12})$ |
|---|---|
| e.g. $\psi=f112(\Delta Bx_{12},\Delta Bz_{12});$ | e.g. $\varphi=f115(\Delta By_{12},\Delta Bz_{12})$ |
| e.g. $\psi=f113(\Delta Bx_{12}/\Delta Bz_{12});$ | e.g. $\varphi=f116(\Delta By_{12}/\Delta Bz_{12})$ |
| e.g. $\psi=atan2(\Delta Bx_{12},\Delta Bz_{12});$ | e.g. $\varphi=atan2(\Delta By_{12},\Delta Bz_{12})$ |

# FIG. 11

$Bx1=(v1+v2);$     $By1=(v3+v4);$
$Bx2=(v5+v6);$     $By2=(v7+v8);$
$\Delta Bx_{12}=dBx/dx=(Bx1-Bx2);$
$\Delta By_{12}=dBy/dx=(By1-By2);$
$D1=Temp\_compensation\_value=f12(Temp)$
----

$\psi=f121(\Delta Bx_{12});$                    $\varphi=f124(\Delta By_{12})$
e.g. $\psi=f122(\Delta Bx_{12},D1);$     e.g. $\varphi=f125(\Delta By_{12},D1)$
e.g. $\psi=f123(\Delta Bx_{12}/D1);$     e.g. $\varphi=f126(\Delta By_{12}/D1)$
e.g. $\psi=\arcsin(\Delta Bx_{12}/D1);$     e.g. $\varphi=\arcsin(\Delta By_{12}/D1)$

## FIG. 12

$Bx1=(v1+v2);$    $By1=(v3+v4);$
$Bx2=(v5+v6);$    $By2=(v7+v8);$
$Bxc=(v9+v10);$    $Byc=(v11+v12);$    $Bzc=(h3);$
$\Delta Bx_{12}=dBx/dx=(Bx1-Bx2);$
$\Delta By_{12}=dBy/dx=(By1-By2);$
$D2=sqr(Bxc)+sqr(Byc)+sqr(Bzc)$

----

| $\psi=f131(\Delta Bx_{12});$ | $\varphi=f134(\Delta By_{12})$ |
| e.g. $\psi=f132(\Delta Bx_{12},\sqrt{D2});$ | e.g. $\varphi=f135(\Delta By_{12},\sqrt{D2})$ |
| e.g. $\psi=f133(\Delta Bx_{12}/\sqrt{D2});$ | e.g. $\varphi=f136(\Delta By_{12}/\sqrt{D2})$ |
| e.g. $\psi=arcsin(\Delta Bx_{12}/\sqrt{D2});$ | e.g. $\varphi=arcsin(\Delta By_{12}/\sqrt{D2})$ |

# FIG. 13

φ (or β)

1401

S3   C   S4

Z
X⊙→Y

## FIG. 14A

φ (or β)

1401

S3   C   S4

Z
X⊙→Y

## FIG. 14B

X
Y
X

S1
S3   C   S4
S2

X
Y
X

S1
S3   C   S4
S2

**FIG. 15**

$Bx1=(h1-h2);\ Bz1=(h1+h2);$
$Bx2=(h3-h4);\ Bz2=(h3+h4);$
$Bx3=v3;\qquad Bx4=v4;$
$\Delta Bx_{12}=dBx/dx=(Bx1-Bx2);$
$\Delta Bz_{12}=dBz/dx=(Bz1-Bz2);$
$\Delta Bx_{34}=dBx/dy=(Bx3-Bx4);$

----

$\psi=f161(\Delta Bx_{12});$

e.g. $\psi=f162(\Delta Bx_{12},\Delta Bz_{12});$

e.g. $\psi=atan2(\Delta Bx_{12},\Delta Bz_{12});$

$\varphi=f163(\Delta Bx_{34})$

e.g. $\varphi=f164(\Delta Bx_{34},\Delta Bz_{12})$

e.g. $\varphi=atan2(\Delta Bx_{34},\Delta Bz_{12})$

## FIG. 16

Bx1=v1;  Bz1=h1;
Bx2=v2;  Bz2=h2;
Bx3=v3;  Bx4=v4;
$\Delta Bx_{12}=dBx/dx=(Bx1-Bx2)$;
$\Delta Bz_{12}=dBz/dx=(Bz1-Bz2)$;
$\Delta Bx_{34}=dBx/dy=(Bx3-Bx4)$;
----

$\psi=f171(\Delta Bx_{12})$;                          $\varphi=f173(\Delta Bx_{34})$
e.g. $\psi=f172(\Delta Bx_{12},\Delta Bz_{12})$;    e.g. $\varphi=f174(\Delta Bx_{34},\Delta Bz_{12})$
e.g. $\psi=atan2(\Delta Bx_{12},\Delta Bz_{12})$;    e.g. $\varphi=atan2(\Delta Bx_{34},\Delta Bz_{12})$

**FIG. 17**

FIG. 18

$Bx1=(h1-h2)$; $Bz1=(h1+h2)$; $Bx2=(h3-h4)$; $Bz2=(h3+h4)$;
$Bx3=(h5-h6)$; $Bz3=(h5+h6)$; $Bx4=(h7-h8)$; $Bz4=(h7+h8)$;
$\Delta Bx_{12}=dBx/dx=(Bx1-Bx2)$;     $\Delta Bz_{12}=dBz/dx=(Bz1-Bz2)$;
$\Delta Bx_{34}=dBx/dy=(Bx3-Bx4)$;     $\Delta Bz_{34}=dBz/dy=(Bz3-Bz4)$;
----

| | |
|---|---|
| $\psi=f180(\Delta Bx_{12})$; | $\varphi=f185(\Delta Bx_{34})$ |
| e.g. $\psi=f181(\Delta Bx_{12},\Delta Bz_{12})$; | e.g. $\varphi=f186(\Delta Bx_{34},\Delta Bz_{12})$ |
| e.g. $\psi=f182(\Delta Bx_{12}/\Delta Bz_{12})$; | e.g. $\varphi=f187(\Delta Bx_{34}/\Delta Bz_{12})$ |
| e.g. $\psi=f183(\Delta Bx_{12},\Delta Bz_{34})$; | e.g. $\varphi=f188(\Delta Bx_{34},\Delta Bz_{34})$ |
| e.g. $\psi=f184(\Delta Bx_{12}/\Delta Bz_{34})$; | e.g. $\varphi=f189(\Delta Bx_{34}/\Delta Bz_{34})$ |
| e.g. $\psi=atan2(\Delta Bx_{12},\Delta Bz_{12})$; | e.g. $\varphi=atan2(\Delta Bx_{34},\Delta Bz_{12})$ |
| e.g. $\psi=atan2(\Delta Bx_{12},\Delta Bz_{34})$; | e.g. $\varphi=atan2(\Delta Bx_{34},\Delta Bz_{34})$ |

Bx1=v1; Bx2=v2; Bx3=v3; Bx4=v4;

$\Delta Bx_{12}$=dBx/dx=(Bx1-Bx2);

$\Delta Bx_{34}$=dBx/dy=(Bx3-Bx4);

D1=Temp_compensation_value=f18(Temp)

----

| | |
|---|---|
| $\psi$=f190($\Delta Bx_{12}$); | $\varphi$=f195($\Delta Bx_{34}$) |
| e.g. $\psi$=f191($\Delta Bx_{12}$,D1); | e.g. $\varphi$=f196($\Delta Bx_{34}$,D1) |
| e.g. $\psi$=f192($\Delta Bx_{12}$/D1); | e.g. $\varphi$=f197($\Delta Bx_{34}$/D1) |
| e.g. $\psi$=arcsin($\Delta Bx_{12}$/D1); | e.g. $\varphi$=arcsin($\Delta Bx_{34}$/D1) |

1903

# FIG. 19

Bx1=v1; Bx2=v2; Bx3=v3; Bx4=v4;
Bxc=(v9+v10); Byc=(v11+v12); Bzc=(h3);
$\Delta Bx_{12}$=dBx/dx=(Bx1-Bx2);
$\Delta Bx_{34}$=dBx/dy=(Bx3-Bx4);
D2=sqr(Bxc)+sqr(Byc)+sqr(Bzc);

----

| | |
|---|---|
| $\psi$=f200($\Delta Bx_{12}$); | $\varphi$=f205($\Delta Bx_{34}$) |
| e.g. $\psi$=f201($\Delta Bx_{12}$,$\sqrt{D2}$); | e.g. $\varphi$=f206($\Delta Bx_{34}$,$\sqrt{D2}$) |
| e.g. $\psi$=f202($\Delta Bx_{12}$/$\sqrt{D2}$); | e.g. $\varphi$=f207($\Delta Bx_{34}$/$\sqrt{D2}$) |
| e.g. $\psi$=arcsin($\Delta Bx_{12}$/$\sqrt{D2}$); | e.g. $\varphi$=arcsin($\Delta Bx_{34}$/$\sqrt{D2}$) |

# FIG. 20

Bx1=(h1-h2); Bz1=(h1+h2); Bx2=(h3-h4); Bz2=(h3+h4);
Bx3=(h5-h6); Bz3=(h5+h6); Bx4=(h7-h8); Bz4=(h7+h8);
Bxc=(h9-h10); Bzc=(h9+h10);

$\Delta Bx_{1c}$=(Bxc-Bx1); $\Delta Bx_{c2}$=(Bx2-Bxc); d2Bx/dx2= $(\Delta Bx_{c2}-\Delta Bx_{1c})$=(Bx2-2*Bxc+Bx1)
$\Delta Bz_{1c}$=(Bzc-Bz1); $\Delta Bz_{c2}$=(Bz2-Bzc); d2Bz/dx2= $(\Delta Bz_{c2}-\Delta Bz_{1c})$=(Bz2-2*Bzc+Bz1)
$\Delta Bx_{3c}$=(Bxc-Bx3); $\Delta Bx_{c4}$=(Bx4-Bxc); d2Bx/dy2= $(\Delta Bx_{c4}-\Delta Bx_{3c})$=(Bx4-2*Bxc+Bx3)
$\Delta Bz_{3c}$=(Bzc-Bz3); $\Delta Bz_{c4}$=(Bz4-Bzc); d2Bz/dy2= $(\Delta Bz_{c4}-\Delta Bz_{3c})$=(Bz4-2*Bzc+Bz3)
D4=w1*sqr(d2Bx/dx2) + w2*sqr(dB2x/dy2) + w3*sqr(d2Bz/dx2) + w4*sqr(d2Bz/dy2)

----

$\psi$=f210($\Delta Bx_{12}$);

e.g. $\psi$=f211($\Delta Bx_{12}$,$\sqrt{D4}$);

e.g. $\psi$=f212($\Delta Bx_{12}$/$\sqrt{D4}$);

e.g. $\psi$=arcsin($\Delta Bx_{12}$/$\sqrt{D4}$);

$\varphi$=f215($\Delta Bx_{34}$)

$\varphi$=f216($\Delta Bx_{34}$,$\sqrt{D4}$);

e.g. $\varphi$=f217($\Delta Bx_{34}$/$\sqrt{D4}$);

e.g. $\varphi$=atan2($\Delta Bx_{34}$/$\sqrt{D4}$);

# FIG. 21

# FIG. 22A    FIG. 22B

in YZ-plane, φ

## FIG. 23A

ΔBz$_{12}$(φ)=dBz/dx

φ[°]

## FIG. 23B

ΔBz$_{56}$(φ) =dBz/dy(φ),
at location offset from C

φ[°]

## FIG. 23C

Bx1=(h1-h2); Bz1=(h1+h2);
Bx2=(h3-h4); Bz2=(h3+h4);
Bz5=h5;        Bz6=h6;
$\Delta Bx_{12}$=dBx/dx=(Bx1-Bx2);
$\Delta Bz_{12}$=dBz/dx=(Bz1-Bz2);
$\Delta Bz_{56}$=dBz/dy=(Bz5-Bz6);
----

| | |
|---|---|
| $\psi$=f230($\Delta Bx_{12}$); | $\varphi$=f235($\Delta Bz_{56}$) |
| e.g. $\psi$=f231($\Delta Bx_{12}$,$\Delta Bz_{12}$); | e.g. $\varphi$=f236($\Delta Bz_{56}$,$\Delta Bz_{12}$) |
| e.g. $\psi$=f232($\Delta Bx_{12}$/$\Delta Bz_{12}$); | e.g. $\varphi$=f237($\Delta Bz_{56}$/$\Delta Bz_{12}$) |
| e.g. $\psi$=atan2($\Delta Bx_{12}$,$\Delta Bz_{12}$); | e.g. $\varphi$=atan2($\Delta Bz_{56}$,$\Delta Bz_{12}$) |

# FIG. 24A

**FIG. 24B**

**FIG. 24C**

**FIG. 24D**

2503

Bx1=(h1-h2); Bz1=(h1+h2); Bx2=(h3-h4); Bz2=(h3+h4);
Bz5=h5; Bz6=h6; Bz7=h7; Bz8=h8;
$\Delta Bx_{12}=dBx/dx=(Bx1-Bx2);$
$\Delta Bz_{12}=dBz/dx=(Bz1-Bz2);$
$\Delta Bz_{56}=dBz/dy1=(Bz5-Bz6);$
$\Delta Bz_{78}=dBz/dy2=(Bz7-Bz8);$
$\Delta Bz_{5-8}=(w1^*\Delta Bz_{56})+(w2^*\Delta Bz_{78});$ w1,w2 are weight factors,
  e.g. w1,w2 are predefined constants, or are function of ψ
----

$ψ=f250(\Delta Bx_{12});$
e.g. $ψ=f251(\Delta Bx_{12},\Delta Bz_{12});$
e.g. $ψ=atan2(\Delta Bx_{12},\Delta Bz_{12});$

$φ=f255(\Delta Bz_{56})$
e.g. $φ=f256(\Delta Bz_{56},\Delta Bz_{12})$
e.g. $φ=f257(\Delta Bz_{56},\Delta Bz_{78})$
e.g. $φ=f258(\Delta Bz_{56},\Delta Bz_{78},\Delta Bz_{12})$
e.g. $φ=f259(\Delta Bz_{56},\Delta Bz_{78},\Delta Bz_{12},ψ)$
e.g. $φ=atan2(\Delta Bz_{5-8},\Delta Bz_{12})$

# FIG. 25

Bx1=v1; Bx2=v2; Bz5=h5; Bz6=h6;

$\Delta Bx_{12}=dBx/dx=(Bx1-Bx2)$;

$\Delta Bz_{56}=dBz/dy=(Bz5-Bz6)$;

D1=Temp_compensation_value=f18(Temp)

----

| | |
|---|---|
| $\psi=f261(\Delta Bx_{12})$; | $\phi=f265(\Delta Bz_{56})$ |
| e.g. $\psi=f262(\Delta Bx_{12},D1)$; | e.g. $\phi=f266(\Delta Bz_{56},D1)$ |
| e.g. $\psi=f263(\Delta Bx_{12}/D1)$; | e.g. $\phi=f267(\Delta Bz_{56}/D1)$ |
| e.g. $\psi=\arcsin(\Delta Bx_{12}/D1)$; | e.g. $\phi=f268(\psi,\Delta Bz_{56},D1)$ |

## FIG. 26

2703

$Bx1=v1; Bx2=v2;$

$Bz5=h5; Bz6=h6; Bz7=h7; Bz8=h8;$

$\Delta Bx_{12}=dBxdx=(Bx1-Bx2);$

$D1=Temp\_compensation\_value=f25(Temp)$

$\Delta Bz_{56}=dBz/dy1=(Bz5-Bz6);$

$\Delta Bz_{78}=dBz/dy2=(Bz7-Bz8);$

$\Delta Bz_{5-8}=(w1{*}\Delta Bz_{56})+(w2{*}\Delta Bz_{78});$ w1,w2 are weight factors,
  e.g. w1,w2 are predefined constants, or are function of $\psi$

----

$\psi=f271(\Delta Bx_{12});$
e.g. $\psi=f272(\Delta Bx_{12},D1);$
e.g. $\psi=f273(\Delta Bx_{12}/D1);$
e.g. $\psi=arcsin(\Delta Bx_{12}/D1);$

$\varphi=f275(\Delta Bz_{56})$
e.g. $\varphi=f276(\Delta Bz_{56},\Delta Bz_{78})$
e.g. $\varphi=f277(\Delta Bz_{56},\Delta Bz_{78},\psi)$
e.g. $\varphi=f278(\Delta Bz_{56},\Delta Bz_{78},D1)$
e.g. $\varphi=f279(\Delta Bz_{56},\Delta Bz_{78},D1,\psi)$

# FIG. 27

2831 NV-Memory

M1 → m1

M2 → m2

M3 → m3

M4 → m4

... 

2832
Temp → T

Processing
Circuit
2830

→ ($\psi$ or $\alpha$,
$\varphi$ or $\beta$)

2802

# FIG. 28

Europäisches
Patentamt

European
Patent Office

Office européen
des brevets

# EUROPEAN SEARCH REPORT

**Application Number**

EP 24 17 1140

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y<br>A | EP 1 464 918 A2 (ROBERT SEUFFER GMBH & CO)<br>6 October 2004 (2004-10-06)<br>* abstract; figures 1,2 *<br>* paragraphs [0001], [0022] - [0028],<br>[0030] - [0034] *<br>- - - - - | 1-3,<br>10-14<br>4,15<br>5-9 | INV.<br>G01D5/14<br>G01D3/036<br>G06F3/0338<br>G01B7/30<br>G01R33/00 |
| Y | US 2021/293580 A1 (DUPRE ET AL)<br>23 September 2021 (2021-09-23)<br>* abstract; figure 3(f) *<br>* paragraphs [0255] - [0259] *<br>- - - - - | 4,15 | |
| Y | EP 4 148 395 A1 (MELEXIS TECH SA)<br>15 March 2023 (2023-03-15)<br>* abstract *<br>* paragraphs [0038] - [0041], [0122],<br>[0261] - [0262] *<br>- - - - - | 4,15 | |
| | | | **TECHNICAL FIELDS SEARCHED (IPC)**<br><br>G06F<br>G01D<br>G01B<br>G01R |

The present search report has been drawn up for all claims

| Place of search | Date of completion of the search | Examiner |
|---|---|---|
| Munich | 6 September 2024 | Barthélemy, Matthieu |

EPO FORM 1503 03.82 (P04C01)

## ANNEX TO THE EUROPEAN SEARCH REPORT
## ON EUROPEAN PATENT APPLICATION NO.

EP 24 17 1140

This annex lists the patent family members relating to the patent documents cited in the above-mentioned European search report.
The members are as contained in the European Patent Office EDP file on
The European Patent Office is in no way liable for these particulars which are merely given for the purpose of information.

06-09-2024

| Patent document cited in search report | | Publication date | Patent family member(s) | | Publication date |
|---|---|---|---|---|---|
| EP 1464918 | A2 | 06-10-2004 | DE | 10314838 A1 | 28-10-2004 |
| | | | EP | 1464918 A2 | 06-10-2004 |
| US 2021293580 | A1 | 23-09-2021 | CN | 113432517 A | 24-09-2021 |
| | | | EP | 3885778 A1 | 29-09-2021 |
| | | | EP | 4339633 A2 | 20-03-2024 |
| | | | US | 2021293580 A1 | 23-09-2021 |
| | | | US | 2024125624 A1 | 18-04-2024 |
| EP 4148395 | A1 | 15-03-2023 | EP | 4148395 A1 | 15-03-2023 |
| | | | US | 2023070938 A1 | 09-03-2023 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3875915 A1
- US 20210110239 A1
- EP 4105768 A1
- EP 4357800 A1